# EUROPEAN PATENT APPLICATION

(11) **EP 4 210 111 A1**
(43) Date of publication of application: **12.07.2023**
(21) Application number: 21874491.0
(22) Date of filing: 29.09.2021
(51) Int. Cl.: H01L 29/423, H01L 29/778, H01L 29/808

(54) **HIGH ELECTRON MOBILITY TRANSISTOR HEMT DEVICE, WAFER, PACKAGING DEVICE, AND ELECTRONIC DEVICE**

(30) Priority: 30.09.2020 CN 202011066567
(71) Applicant: Huawei Technologies Co., Ltd., Shenzhen, Guangdong 518129 (CN)
(72) Inventor: ZHANG, Dongliang, Shenzhen, Guangdong 518129 (CN); ZHU, Jianyun, Shenzhen, Guangdong 518129 (CN); WANG, Hang, Shenzhen, Guangdong 518129 (CN); XIE, Feng, Shenzhen, Guangdong 518129 (CN); XIE, Ronghua, Shenzhen, Guangdong 518129 (CN)
(74) Representative: Gill Jennings & Every LLP
(86) International application number: PCT/CN2021/121501
(87) International publication number: WO 2022/068835

(57) **Abstract**

This application is applicable to the field of semiconductor technologies, and provides a high electron mobility transistor HEMT device, a wafer, a packaged device, and an electronic device. The HEMT device includes a substrate, a nitride epitaxial layer, a gate semiconductor structure, a gate metal, a source structure, and a drain structure. The nitride epitaxial layer is disposed on the substrate. The gate semiconductor structure, the source structure, and the drain structure are all disposed on a first surface of the nitride epitaxial layer. The source structure and the drain structure are distributed on two sides of the gate semiconductor structure. The gate semiconductor structure includes a first semiconductor layer and a plurality of n-type semiconductors. The first semiconductor layer is made of a p-type nitride and is located on the first surface. The plurality of n-type semiconductors are located between the first semiconductor layer and the gate metal, and are arranged at spacings in a direction parallel to a gate width direction. The first semiconductor layer may separately form positive space charge regions with the plurality of n-type semiconductors to adjust an interfacial electric field between the gate metal and the gate semiconductor structure, to suppress a gate leakage current.

## Description

This application claims priority to Chinese Patent Application No. 202011066567.0, filed with the China National Intellectual Property Administration on September 30, 2020 and entitled "HIGH ELECTRON MOBILITY TRANSISTOR HEMT DEVICE, WAFER, PACKAGED DEVICE, AND ELECTRONIC DEVICE", which is incorporated herein by reference in its entirety.

### TECHNICAL FIELD

This application relates to the field of semiconductor technologies, and in particular, to a high electron mobility transistor HEMT device, a wafer, a packaged device, and an electronic device.

### BACKGROUND

As semiconductor technologies continuously develop, a power loss of a power semiconductor device needs to be continuously reduced to meet an existing use requirement. Performance of a conventional silicon (Si) device has basically reached a physical limit of Si. As a more advantageous semiconductor material, gallium nitride (GaN) has become a candidate material for a new power semiconductor device.

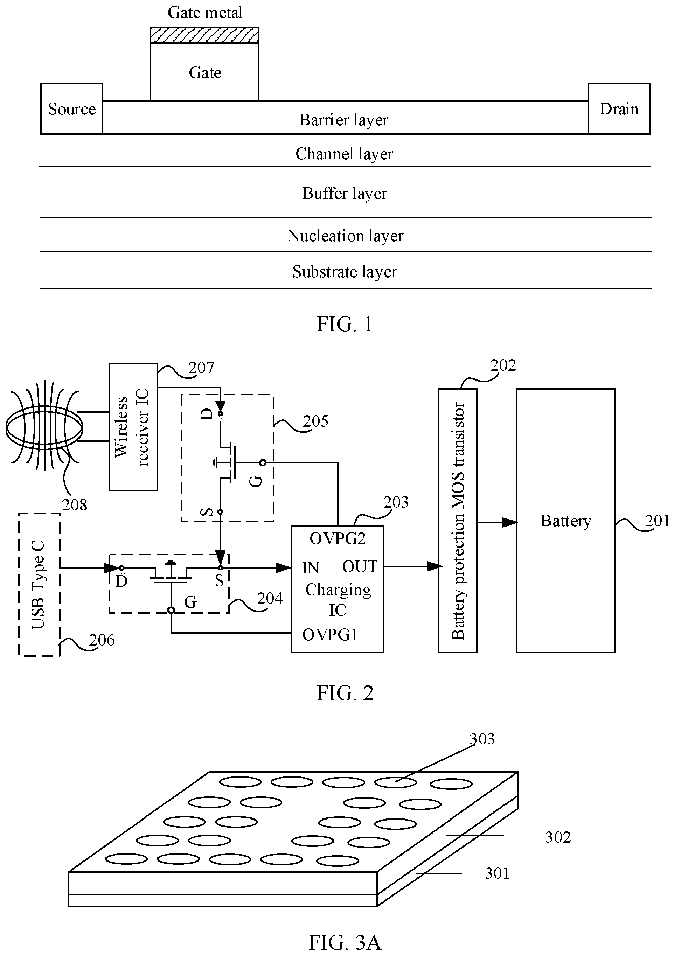

In the conventional technology, a normally-off gallium nitride switching device in the new power semiconductor device may be a high electron mobility transistor (high electron mobility transistor, HEMT) device made of p-type GaN or p-type aluminum gallium nitride (AlGaN). As shown in FIG. 1, the HEMT device may include, from bottom to top, a substrate layer, a nucleation layer, a buffer layer, a channel layer, and a barrier layer. In addition, a gate semiconductor structure is disposed on the barrier layer. The gate semiconductor structure may include a p-type semiconductor layer made of GaN or AlGaN. A gate metal is further disposed on the gate semiconductor structure. In addition, a source and a drain may be disposed on two sides of the gate semiconductor structure.

However, for the HEMT device in the conventional technology, when the gate metal is in a forward bias state, the HEMT device still has a large gate leakage current even if a Schottky junction between the gate metal and the p-type semiconductor layer of the gate semiconductor structure is in a reverse bias state.

### SUMMARY

This application provides a HEMT device, a wafer, a packaged device, and an electronic device to effectively reduce a gate leakage current of a p-type HEMT device (for example, at a same gate voltage, reduce the gate leakage current by at least 1 time, such as 5 to 100 times) on a premise that impact on a characteristic parameter of the HEMT device is small (for example, only a voltage drift from 0.05 volts (V) to 0.1 V occurs in a threshold voltage of the HEMT device).

To achieve the foregoing objective, the following technical solutions are used in this application.

According to a first aspect, a high electron mobility transistor HEMT device is provided, including a substrate, a nitride epitaxial layer, a gate semiconductor structure, a gate metal, a source structure, and a drain structure.

The nitride epitaxial layer is disposed on the substrate. The gate semiconductor structure is disposed on a first surface of the nitride epitaxial layer. The first surface is a surface that is of the nitride epitaxial layer and that is away from the substrate.

The source structure and the drain structure are disposed on the first surface and distributed on two sides of the gate semiconductor structure.

The gate semiconductor structure includes a first semiconductor layer. The first semiconductor layer is made of a p-type nitride. The first semiconductor layer is located on the first surface.

The gate semiconductor structure further includes a plurality of n-type semiconductors. The plurality of n-type semiconductors are located between the first semiconductor layer and the gate metal. The plurality of n-type semiconductors are arranged at spacings in a same direction. The arrangement direction of the plurality of n-type semiconductors is parallel to a gate width direction of the gate semiconductor structure.

The first semiconductor layer and the plurality of n-type semiconductors alternately arranged on a surface of the first semiconductor layer are disposed on a barrier layer. Each n-type semiconductor may form a PN junction with the first semiconductor layer that is in contact with the n-type semiconductor. Therefore, electric field distribution between the gate metal and the semiconductors can be adjusted by using a space charge region of the PN junction, to reduce a probability of carrier transition between the gate metal and the gate semiconductor structure. In this way, a gate leakage current of the HEMT device is reduced, and a gate withstand voltage of the HEMT device is increased.

In addition, in a direction from the barrier layer to the gate metal, the gate semiconductor structure of the HEMT device may include only the first semiconductor layer. Characteristic parameters such as a threshold voltage, a transconductance, and an on impedance closer to those of a conventional p-type HEMT structure can be obtained by using a region that includes only the first semiconductor layer, so that impact of a change in a gate structure on the characteristic parameters of the HEMT device is reduced.

In a first possible implementation of the first aspect, the first semiconductor layer includes a plurality of first protrusion portions. The plurality of n-type semiconductors are disposed in the first semiconductor layer. Every two of the n-type semiconductors are separated by the first protrusion portion.

The plurality of first protrusion portions are disposed, so that the gate metal is in contact with the first protrusion portions. In other words, the gate metal is in contact with surfaces of some p-type semiconductors. This can reduce impact of the plurality of n-type semiconductors on a characteristic of the HEMT device. In addition, the plurality of n-type semiconductors may form longitudinal PN junctions with the first semiconductor layer in a vertical direction. The plurality of first protrusion portions and the plurality of n-type semiconductors may further form transverse PN junctions in a horizontal direction. Carriers in each first protrusion portion may be exhausted by using the n-type semiconductors on two sides of the first protrusion portion, to form a space charge region, so that a leakage current in the gate semiconductor structure can be reduced.

According to the first possible implementation of the first aspect, in a second possible implementation of the first aspect, a surface that is of at least one of the n-type semiconductors and that is close to the gate metal is coplanar with a surface that is of at least one of the first protrusion portions and that is close to the gate metal.

The surface that is of at least one of the n-type semiconductors and that is close to the gate metal is coplanar with the surface that is of at least one of the first protrusion portions and that is close to the gate metal, so that an electric field of the gate semiconductor structure can be uniformly distributed, and impact of electric field concentration on an effect of suppressing the gate leakage current is avoided.

According to any one of the foregoing possible implementations of the first aspect, in a third possible implementation of the first aspect, the gate semiconductor structure further includes a second semiconductor layer. The second semiconductor layer is made of a p-type nitride.

The second semiconductor layer is located on a surface that is of the gate metal and that is close to the first semiconductor layer.

The second semiconductor layer is added, so that the electric field of the gate semiconductor structure can be further optimized, and the impact of the electric field concentration on the effect of suppressing the gate leakage current can be avoided. In addition, because an etching process aggravates electric leakage of side walls of the first semiconductor layer and the plurality of n-type semiconductors, the electric leakage of the side walls of the first semiconductor layer and the plurality of n-type semiconductors can be avoided by adding the second semiconductor layer. In this way, the gate leakage current of the HEMT device is reduced.

In a fourth possible implementation of the first aspect, the gate metal includes a plurality of second protrusion portions. The plurality of n-type semiconductors are disposed in the gate metal. Every two of the n-type semiconductors are separated by the second protrusion portion.

Space between the plurality of n-type semiconductors is filled with the second protrusion portions of the gate metal. The space between the plurality of n-type semiconductors does not need to be filled with another material. This can be implemented only by using a metal deposition process. In comparison with that in another implementation of the first aspect, a process of manufacturing the HEMT device can be simplified, and costs of manufacturing the HEMT device can be further reduced.

In a fifth possible implementation of the first aspect, space between the plurality of n-type semiconductors is filled with an insulation dielectric.

The space between the plurality of n-type semiconductors is filled with the insulation dielectric. The insulation dielectric is non-conductive, so that a gate leakage current between adjacent n-type semiconductors can be reduced.

According to any one of the foregoing possible implementations of the first aspect, in a sixth possible implementation of the first aspect, the plurality of n-type semiconductors are arranged at equal spacings.

The n-type semiconductors are arranged at equal spacings, so that the electric field of the gate semiconductor structure can be uniformly arranged, and the impact of the electric field concentration on the effect of suppressing the gate leakage current can be avoided. In addition, the plurality of n-type semiconductors are arranged at equal spacings, so that each n-type semiconductor can play a same or similar role in the HEMT device. Therefore, uniformity of the HEMT device in a plurality of aspects such as an on voltage and an on resistance can be improved.

In addition, a shape and a size of the n-type semiconductor in the gate is adjusted to reduce impact of the n-type semiconductor on the electric field of the gate semiconductor structure and reduce an electric field in a gate region. This further reduces the gate leakage current of the HEMT device and impact of the n-type semiconductor on the characteristic parameter of the HEMT device.

According to a second aspect, a HEMT device is provided, including a substrate, a nitride epitaxial layer, a gate semiconductor structure, a gate metal, a source structure, and a drain structure.

The nitride epitaxial layer is disposed on the substrate. The gate semiconductor structure is disposed on a first surface of the nitride epitaxial layer. The first surface is a surface that is of the nitride epitaxial layer and that is away from the substrate.

The source structure and the drain structure are disposed on the first surface and distributed on two sides of the gate semiconductor structure.

The gate semiconductor structure includes a first semiconductor layer. The first semiconductor layer is made of a p-type nitride. The first semiconductor layer is located on the first surface.

The gate semiconductor structure further includes a second semiconductor layer. The second semiconductor layer is a p-type semiconductor layer, an n-type semiconductor layer, or an unintentionally doped semiconductor layer. The second semiconductor layer is located on a surface that is of the gate metal and that is close to the first semiconductor layer.

A band gap width of the second semiconductor layer is greater than a band gap width of the first semiconductor layer, or a total polarization intensity of the second semiconductor layer is greater than a total polarization intensity of the first semiconductor layer.

The HEMT device with a laminated gate structure is disposed on a barrier layer, so that a band gap width of a part closer to the gate metal increases. Therefore, a Schottky barrier height between the metal and a semiconductor is increased. To be specific, a Schottky barrier height between the gate metal and the second semiconductor layer is increased. A probability of carrier transition between the gate metal and the second semiconductor layer is reduced. In addition, the total polarization intensity of the second semiconductor layer is greater than that of the first semiconductor layer. In this way, by introducing positive polarization charges into the second semiconductor layer, an electric field at an interface between the gate metal and the second semiconductor layer can be adjusted, the probability of the carrier transition between the gate metal and the second semiconductor layer is further reduced, a gate leakage current of the HEMT device is reduced, and a withstand voltage of the gate semiconductor structure is increased.

In a first possible implementation of the second aspect, the second semiconductor layer is made of a nitride including an aluminum component.

The band gap width of the second semiconductor layer can be increased by adding the aluminum component to the second semiconductor layer, so that the Schottky barrier height between the metal and the semiconductor can be increased. To be specific, the Schottky barrier height between the gate metal and the second semiconductor layer is increased. In this way, the probability of the carrier transition between the gate metal and the second semiconductor layer can be reduced, and the gate leakage current of the HEMT device can be reduced.

According to the first possible implementation of the second aspect, in a second possible implementation of the second aspect, the first semiconductor layer is made of a nitride including an aluminum component.

A percentage of the aluminum component at the first semiconductor layer is lower than a percentage of the aluminum component at the second semiconductor layer.

The aluminum component is added to both the first semiconductor layer and the second semiconductor layer, and the percentage of the aluminum component at the second semiconductor layer is higher than or equal to the percentage of the aluminum component at the first semiconductor layer, so that the band gap width of the first semiconductor layer can be increased by using the aluminum component, and the band gap width of the second semiconductor layer can be further increased by using the aluminum component. In this way, the probability of the carrier transition between the gate metal and the second semiconductor layer can be further reduced, and the gate leakage current of the HEMT device can be reduced.

When material components of the second semiconductor layer are different from those of the first semiconductor layer, components occupied by different materials (for example, aluminum) in the second semiconductor layer may be adjusted, to increase the band gap width of the second semiconductor layer, so that the Schottky barrier height between the gate metal and the gate semiconductor structure can be effectively increased. Alternatively, positive polarization charges are introduced into the second semiconductor layer, so that the probability of the carrier transition between the gate metal and the gate semiconductor structure when the gate is in a forward bias state is further reduced, the gate leakage current of the HEMT device is reduced, and a gate withstand voltage of the HEMT device is increased.

According to the first or second possible implementation of the second aspect, in a third possible implementation of the second aspect, the percentage of the aluminum component at the second semiconductor layer is kept uniform.

Alternatively, the percentage of the aluminum component at the second semiconductor layer gradually decreases in a direction from the gate metal to the first semiconductor layer.

Alternatively, the percentage of the aluminum component at the second semiconductor layer gradiently decreases in a direction from the gate metal to the first semiconductor layer.

The aluminum component at the second semiconductor layer is distributed in a uniform, gradual, or gradient manner, so that an electric field peak value of the gate semiconductor structure can be reduced, an electric field can be optimized, and impact of electric field concentration on an effect of suppressing the gate leakage current can be avoided. In addition, in a process of generating the second semiconductor layer, a lattice mismatch phenomenon is reduced due to impact of a distribution manner of the aluminum component, so that quality of the generated second semiconductor layer can be improved.

According to any one of the foregoing possible implementations of the second aspect, in a fourth possible implementation of the second aspect, a doping density of the second semiconductor layer is kept uniform.

Alternatively, a doping density of the second semiconductor layer gradually increases in the direction from the gate metal to the first semiconductor layer.

Alternatively, a doping density of the second semiconductor layer gradiently increases in the direction from the gate metal to the first semiconductor layer.

The doping density of the second semiconductor layer is adjusted to be distributed in a uniform, gradual, or gradient manner, so that an electric field at an interface between the first semiconductor layer and the second semiconductor layer can be mitigated, and an electric field peak value can be reduced. In this way, electric field distribution is more uniform, and the impact of the electric field concentration on the effect of suppressing the gate leakage current is avoided.

According to a third aspect, a HEMT device is provided, including a substrate, a nitride epitaxial layer, a gate semiconductor structure, a gate metal, a source structure, and a drain structure.

The nitride epitaxial layer is disposed on the substrate. The gate semiconductor structure is disposed on a first surface of the nitride epitaxial layer. The first surface is a surface that is of the nitride epitaxial layer and that is away from the substrate.

The source structure and the drain structure are disposed on the first surface and distributed on two sides of the gate semiconductor structure.

The gate semiconductor structure includes a first semiconductor layer. The first semiconductor layer is made of a p-type nitride. The first p-type semiconductor layer is disposed on the first surface.

The gate semiconductor structure further includes a second semiconductor layer and a third semiconductor layer. The second semiconductor layer is made of an n-type nitride or an unintentionally doped nitride. The third semiconductor layer is made of a p-type nitride.

The third semiconductor layer is located on a surface that is of the gate metal and that is close to the first semiconductor layer. The second semiconductor layer is located between the first semiconductor layer and the third semiconductor layer. The first semiconductor, the second semiconductor, and the third semiconductor form a PNP gate semiconductor structure.

The nitride PNP gate semiconductor structure is disposed on the barrier layer, so that the n-type nitride at the second semiconductor layer in the PNP gate semiconductor structure can interact with the p-type nitride at the first semiconductor layer and the third semiconductor layer to form a positive space charge region in a region of the second semiconductor layer, to repel holes in the gate metal from entering the gate PNP structure. In this way, a gate leakage current is reduced.

In addition, when the gate is at a high level, the positive space charge region can reduce an interfacial electric field between the gate metal and the third semiconductor layer, to reduce a probability of carrier transition between the gate metal and the gate semiconductor structure. In this way, the gate leakage current of the HEMT device is reduced, and reliability of the HEMT device is improved.

In addition, the first semiconductor layer in the PNP structure is in contact with the barrier layer. Induced negative polarization charges at the first semiconductor layer may supplement positive polarization charges at the barrier layer. Therefore, a density of two-dimensional electron gas at the channel layer can be reduced, so that the HEMT device can be normally off.

In a first possible implementation of the third aspect, a doping density of the third semiconductor layer is less than or equal to a doping density of the first semiconductor layer. The doping density of the third semiconductor layer is kept uniform, gradually changes, or gradiently changes. A doping density of the second semiconductor layer is kept uniform, gradually changes, gradiently changes, or is unintentional.

An electric field at an interface between the first semiconductor layer and the second semiconductor layer and an electric field at an interface between the second semiconductor layer and the third semiconductor layer can be mitigated by adjusting the doping densities of the first semiconductor layer, the second semiconductor layer, and the third semiconductor layer, and an electric field peak value can be reduced. In this way, electric field distribution is more uniform, and impact of electric field concentration on an effect of suppressing the gate leakage current is avoided.

According to any one of the possible implementations of the first aspect, the second aspect, and the third aspect, in a first possible implementation, the substrate is a heterogeneous epitaxial substrate or a homogeneous epitaxial substrate. The heterogeneous epitaxial substrate is made of silicon, sapphire, or silicon carbide. The homogeneous epitaxial substrate is made of gallium nitride.

Different substrates are used, so that quality of the epitaxial layer grown on the substrate can be optimized. Therefore, performance of the HEMT device can be improved.

According to any one of the possible implementations of the first aspect, the second aspect, and the third aspect, in a second possible implementation, the nitride epitaxial layer includes a nucleation layer disposed on the substrate, a buffer layer disposed on the nucleation layer, a channel layer disposed on the buffer layer, and a barrier layer disposed on the channel layer.

The nucleation layer is made of aluminum nitride. The buffer layer is made of aluminum gallium nitride or gallium nitride. The channel layer is made of undoped gallium nitride. The barrier layer is made of aluminum gallium nitride, indium aluminum nitride, or indium aluminum gallium nitride.

Different materials are used to generate a plurality of epitaxial layers such as the nucleation layer, the buffer layer, the channel layer, and the barrier layer, so that quality of the epitaxial layers can be optimized. Therefore, performance of the HEMT device can be improved.

According to any one of the possible implementations of the first aspect, the second aspect, and the third aspect, in a third possible implementation, the source structure and the drain structure are symmetrically distributed on the two sides of the gate semiconductor structure.

In a manner of symmetrically disposing the source structure and the drain structure, a HEMT device applied to a wired charging scenario or a wireless charging scenario may have a bidirectional voltage withstand shutdown function when turned off.

According to any one of the possible implementations of the first aspect, the second aspect, and the third aspect, in a fourth possible implementation, the first semiconductor layer or the second semiconductor layer is made of gallium nitride, aluminum gallium nitride, indium gallium nitride, indium aluminum nitride, or indium aluminum gallium nitride.

Different materials are used to generate the first semiconductor layer and/or the second semiconductor layer, so that the band gap width of the first semiconductor layer and/or the second semiconductor layer can be increased. The Schottky barrier height between the metal and the semiconductor can be increased. The probability of the carrier transition between the gate metal and the second semiconductor layer or between the gate metal and the first semiconductor layer can be reduced. Therefore, the gate leakage current of the HEMT device is reduced, and the withstand voltage of the gate semiconductor structure is increased.

According to a fourth aspect, a wafer is provided. The wafer includes the HEMT device according to any one of the first aspect, the second aspect, and the third aspect.

According to a fifth aspect, a packaged device is provided. The packaged device includes the HEMT device according to any one of the first aspect, the second aspect, and the third aspect.

The HEMT device according to any one of the first aspect, the second aspect, and the third aspect is added to the packaged device, so that power consumption of the packaged device can be reduced on a basis that the HEMT device can reduce a gate leakage current.

According to a sixth aspect, an electronic device is provided. The electronic device includes the HEMT device according to any one of the first aspect, the second aspect, and the third aspect.

The HEMT device according to any one of the first aspect, the second aspect, and the third aspect is added to the electronic device, so that gate reliability of the HEMT device is improved on a basis that the HEMT device can reduce a gate leakage current, and working security of the electronic device is improved. In addition, a gate driving capability of the HEMT device can be improved, a gate breakdown voltage can be increased, a working voltage can be increased, and an on impedance can be reduced, so that power consumption of the electronic device is further reduced.

According to a seventh aspect, an electronic device is provided. The electronic device includes a charging integrated circuit, a wired charging interface, and at least one HEMT device according to any one of the first aspect, the second aspect, and the third aspect. The at least one HEMT device includes a first HEMT device.

A gate structure of the first HEMT device is connected to a first control terminal of the charging integrated circuit. A drain structure of the first switching device is connected to the wired charging interface. A source structure of the first switching device is connected to an input terminal of the charging integrated circuit.

An output terminal of the charging integrated circuit is connected to a battery.

The HEMT device according to any one of the first aspect, the second aspect, and the third aspect is added to the electronic device, so that during charging in a wired charging manner, gate reliability of the HEMT device is improved on a basis that the HEMT device can reduce a gate leakage current. Therefore, working security of the electronic device is improved. In addition, a gate driving capability of the HEMT device can be improved, so that power consumption during the charging can be further reduced.

In a first possible implementation of the seventh aspect, the electronic device further includes a wireless receiver integrated circuit and a wireless charging coil. The at least one HEMT device further includes a second HEMT device.

A gate structure of the second HEMT device is connected to a second control terminal of the charging integrated circuit. A drain structure of the second HEMT device is connected to the wireless charging coil by using the wireless receiver integrated circuit. A source structure of the second HEMT device is connected to the input terminal of the charging integrated circuit.

The HEMT device according to any one of the first aspect, the second aspect, and the third aspect is added to the electronic device, so that during charging in a wireless charging manner, gate reliability of the HEMT device is improved on a basis that the HEMT device can reduce a gate leakage current. Therefore, working security of the electronic device is improved. In addition, a gate driving capability of the HEMT device can be improved, so that power consumption during the charging can be further reduced. In addition, on a basis that the HEMT device has a bidirectional voltage withstand shutdown function, security of performing wired and wireless shared charging by the electronic device can be improved.

### BRIEF DESCRIPTION OF DRAWINGS

FIG. 1 is a schematic sectional view of a HEMT device in the conventional technology;
FIG. 2 is a schematic diagram of a system architecture related to a HEMT device according to an embodiment of this application;
FIG. 3A is a schematic diagram of a packaged device according to an embodiment of this application;
FIG. 3B is a schematic diagram of arrangement of surface-implanted balls of a packaged device according to an embodiment of this application;
FIG. 4A is a schematic diagram of a structure of a HEMT device in the conventional technology;
FIG. 4B is a schematic diagram of doping density distribution of a gate p-type layer in a HEMT device in the conventional technology;
FIG. 5A is a schematic sectional view of a HEMT device according to an embodiment of this application;
FIG. 5B is a schematic top view of a HEMT device according to an embodiment of this application;
FIG. 5C is a flowchart of a process of manufacturing a HEMT device according to an embodiment of this application;
FIG. 5D is a schematic diagram of a structure of a HEMT device when the HEMT device is manufactured according to an embodiment of this application;
FIG. 5E is a schematic diagram of a structure of a HEMT device when the HEMT device is manufactured according to an embodiment of this application;
FIG. 5F is a schematic diagram of a structure of a HEMT device when the HEMT device is manufactured according to an embodiment of this application;
FIG. 5G is a schematic diagram of a structure of a HEMT device when the HEMT device is manufactured according to an embodiment of this application;
FIG. 5H is a schematic diagram of a structure of a HEMT device when the HEMT device is manufactured according to an embodiment of this application;
FIG. 5I is a schematic diagram of a structure of a HEMT device when the HEMT device is manufactured according to an embodiment of this application;
FIG. 5J is a schematic diagram of a structure of a HEMT device when the HEMT device is manufactured according to an embodiment of this application;
FIG. 5K is a schematic diagram of a structure of a HEMT device when the HEMT device is manufactured according to an embodiment of this application;
FIG. 5L is a schematic diagram of a structure of a HEMT device when the HEMT device is manufactured according to an embodiment of this application;
FIG. 5M is a schematic diagram of a structure of a HEMT device when the HEMT device is manufactured according to an embodiment of this application;
FIG. 5N is a schematic diagram of a structure of a HEMT device when the HEMT device is manufactured according to an embodiment of this application;
FIG. 5O is a schematic diagram of reference numerals of a simulation structure of a HEMT device according to an embodiment of this application;
FIG. 5P is a simulation curve diagram of a threshold voltage of a HEMT device according to an embodiment of this application;
FIG. 5Q is a simulation curve diagram of a gate leakage current of a HEMT device according to an embodiment of this application;
FIG. 5R is a simulation curve diagram of a gate withstand voltage of a HEMT device according to an embodiment of this application;
FIG. 6A is a schematic diagram of a structure of a HEMT device with a graphical gate according to an embodiment of this application;
FIG. 6B is a schematic top view of a HEMT device with a graphical gate according to an embodiment of this application;
FIG. 6C is a schematic sectional view of a HEMT device with a graphical gate according to an embodiment of this application;
FIG. 6D is a schematic sectional view of a HEMT device with a graphical gate according to an embodiment of this application;
FIG. 6E is a schematic sectional view of a HEMT device with a graphical gate according to an embodiment of this application;
FIG. 6F is a flowchart of a process of manufacturing a HEMT device with a graphical gate according to an embodiment of this application;
FIG. 6G is a schematic diagram of a structure of a HEMT device with a graphical gate when the HEMT device is manufactured according to an embodiment of this application;
FIG. 6H is a schematic diagram of a structure of a HEMT device with a graphical gate when the HEMT device is manufactured according to an embodiment of this application;
FIG. 6I is a schematic diagram of a structure of a HEMT device with a graphical gate when the HEMT device is manufactured according to an embodiment of this application;
FIG. 6J is a schematic diagram of a structure of a HEMT device with a graphical gate when the HEMT device is manufactured according to an embodiment of this application;
FIG. 6K is a schematic diagram of a structure of a HEMT device with a graphical gate when the HEMT device is manufactured according to an embodiment of this application;
FIG. 6L is a schematic diagram of reference numerals of a simulation structure of a HEMT device with a graphical gate according to an embodiment of this application;
FIG. 6M is a schematic diagram of reference numerals of a simulation structure of a HEMT device with a graphical gate according to an embodiment of this application;
FIG. 6N is a simulation curve diagram of a threshold voltage of a HEMT device with a graphical gate according to an embodiment of this application;
FIG. 6O is a simulation curve diagram of a gate leakage current of a HEMT device with a graphical gate according to an embodiment of this application;
FIG. 6P is a simulation curve diagram of a gate withstand voltage of a HEMT device with a graphical gate according to an embodiment of this application;
FIG. 7A is a schematic diagram of a structure of another HEMT device with a graphical gate according to an embodiment of this application;
FIG. 7B is a schematic top view of another HEMT device with a graphical gate according to an embodiment of this application;
FIG. 7C is a schematic sectional view of another HEMT device with a graphical gate according to an embodiment of this application;
FIG. 7D is a schematic sectional view of another HEMT device with a graphical gate according to an embodiment of this application;
FIG. 7E is a schematic sectional view of another HEMT device with a graphical gate according to an embodiment of this application;
FIG. 7F is a flowchart of a process of manufacturing another HEMT device with a graphical gate according to an embodiment of this application;
FIG. 7G is a schematic diagram of a structure of another HEMT device with a graphical gate when the HEMT device is manufactured according to an embodiment of this application;
FIG. 7H is a schematic diagram of a structure of another HEMT device with a graphical gate when the HEMT device is manufactured according to an embodiment of this application;
FIG. 7I is a schematic diagram of a structure of another HEMT device with a graphical gate when the HEMT device is manufactured according to an embodiment of this application;
FIG. 7J is a schematic diagram of a structure of another HEMT device with a graphical gate when the HEMT device is manufactured according to an embodiment of this application;
FIG. 7K is a schematic diagram of a structure of another HEMT device with a graphical gate when the HEMT device is manufactured according to an embodiment of this application;
FIG. 8A is a schematic diagram of a structure of still another HEMT device with a graphical gate according to an embodiment of this application;
FIG. 8B is a schematic top view of still another HEMT device with a graphical gate according to an embodiment of this application;
FIG. 8C is a schematic sectional view of still another HEMT device with a graphical gate according to an embodiment of this application;
FIG. 8D is a schematic sectional view of still another HEMT device with a graphical gate according to an embodiment of this application;
FIG. 8E is a schematic sectional view of still another HEMT device with a graphical gate according to an embodiment of this application;
FIG. 8F is a flowchart of a process of manufacturing still another HEMT device with a graphical gate according to an embodiment of this application;
FIG. 9A is a schematic sectional view of another HEMT device according to an embodiment of this application;
FIG. 9B is a schematic top view of another HEMT device according to an embodiment of this application;
FIG. 9C is a schematic diagram of an Al component change at a second semiconductor layer in another HEMT device according to an embodiment of this application;
FIG. 9D is a schematic diagram of an Al component change at another second semiconductor layer in another HEMT device according to an embodiment of this application;
FIG. 9E is a schematic diagram of an Al component change at still another second semiconductor layer in another HEMT device according to an embodiment of this application;
FIG. 9F is a flowchart of a process of manufacturing another HEMT device according to an embodiment of this application;
FIG. 9G is a schematic diagram of a structure of another HEMT device when the HEMT device is manufactured according to an embodiment of this application;
FIG. 9H is a schematic diagram of a structure of another HEMT device when the HEMT device is manufactured according to an embodiment of this application;
FIG. 9I is a schematic diagram of a structure of another HEMT device when the HEMT device is manufactured according to an embodiment of this application;
FIG. 9J is a schematic diagram of a structure of another HEMT device when the HEMT device is manufactured according to an embodiment of this application;
FIG. 9K is a schematic diagram of reference numerals of a simulation structure of another HEMT device according to an embodiment of this application;
FIG. 9L is a simulation curve diagram of a threshold voltage of another HEMT device according to an embodiment of this application;
FIG. 9M is a simulation curve diagram of a gate leakage current of another HEMT device according to an embodiment of this application; and
FIG. 9N is a simulation curve diagram of a gate withstand voltage of another HEMT device according to an embodiment of this application.

### DESCRIPTION OF EMBODIMENTS

In the following description, to illustrate rather than limit, specific details such as a particular system structure and a technology are provided to make a thorough understanding of embodiments of this application. However, a person skilled in the art should know that this application may be implemented in other embodiments without these specific details. In other cases, detailed descriptions of well-known circuits and methods are omitted, so that this application is described without being obscured by unnecessary details.

Terms used in the following embodiments are merely intended to describe particular embodiments, but are not intended to limit this application. The terms "one", "the", "the foregoing", and "this" of singular forms used in this specification and the appended claims of this application are also intended to include expressions such as "one or more", unless otherwise specified in the context clearly.

FIG. 2 is a schematic diagram of a system architecture related to a HEMT device according to an embodiment of this application. By way of example rather than limitation, as shown in FIG. 2, the system architecture may include a battery 201, a battery protection metal-oxide-semiconductor (metal-oxide-semiconductor, MOS) transistor 202, a charging integrated circuit (integrated circuit, IC) 203, an overvoltage protection switch 204, a transfer switch 205, a universal serial bus (universal serial bus, USB) Type C interface 206, a wireless receiver IC 207, and a wireless charging coil 208.

Both the overvoltage protection switch 204 and the transfer switch 205 may include a HEMT device provided in embodiments of this application. In the overvoltage protection switch 204, a drain D of the HEMT device is connected to the USB Type C interface 206, a source S of the HEMT device is connected to an input terminal IN of the charging IC 203, and a gate G of the HEMT device is connected to a first overvoltage protection port OVPG1 of the charging IC 203.

In addition, in the transfer switch 205, a drain D of the HEMT device is connected to an output terminal of the wireless receiver IC 207, a source S of the HEMT device is connected to the input terminal IN of the charging IC 203, and a gate G of the HEMT device is connected to a second overvoltage protection port OVPG2 of the charging IC 203.

In addition, an output terminal OUT of the charging IC 203 is connected to the battery 201 through the battery protection MOS transistor 202, and an input terminal of the wireless receiver IC 207 is connected to an output terminal of the wireless charging coil 208.

It should be noted that when the HEMT device provided in embodiments of this application is used in the overvoltage protection switch 204 and the transfer switch 205, the source S and the drain D of the HEMT device need to be basically symmetrically arranged on two sides of the gate G, to implement a bidirectional voltage withstand function of the HEMT device. However, the source S and the drain D of the HEMT device provided in embodiments of this application may be symmetrically arranged on the two sides of the gate G or may be asymmetrically arranged on the two sides of the gate G. Arrangement positions of the source S and the drain D of the HEMT device are not limited in embodiments of this application.

The foregoing system architecture includes the USB Type C interface 206 used for wired charging, and also includes the wireless receiver IC 207 and the wireless charging coil 208 used for wireless charging. In this case, in a process of charging the battery 201, a wired charging manner or a wireless charging manner may be used.

During charging in the wired charging manner, the first overvoltage protection port OVPG1 of the charging IC 203 may output a high level signal. The gate G of the HEMT device in the overvoltage protection switch 204 may receive the high level signal, so that the HEMT device in the overvoltage protection switch 204 is turned on. In this way, the battery 201 can be charged through the USB Type C interface 206.

In addition, the second overvoltage protection port OVPG2 of the charging IC 203 may output a low level signal. The gate G of the HEMT device in the transfer switch 205 may receive the low level signal, so that the HEMT device in the transfer switch 205 is turned off. In this way, a charging current flowing through the overvoltage protection switch 204 can be prevented from flowing back into the transfer switch 205 and the wireless receiver IC 207.

When the USB Type C interface 206 has a surge voltage, the first overvoltage protection port OVPG1 of the charging IC 203 may output a low level signal. The gate G of the HEMT device in the overvoltage protection switch 204 may turn off the HEMT device based on the low level signal. In this way, the charging IC 203 can be prevented from being damaged by the surge voltage.

During charging in the wireless charging manner, the second overvoltage protection port OVPG2 of the charging IC 203 may output a high level signal. The gate G of the HEMT device in the transfer switch 205 may receive the high level signal, so that the HEMT device in the transfer switch 205 is turned on. In this way, the battery 201 can be charged through the wireless receiver IC 207 and the wireless charging coil 208.

In addition, the first overvoltage protection port OVPG1 of the charging IC 203 may output a low level signal. The gate G of the HEMT device in the overvoltage protection switch 204 may receive the low level signal, so that the HEMT device in the overvoltage protection switch 204 is turned off. In this way, a charging current flowing through the transfer switch 205 can be prevented from flowing back into the overvoltage protection switch 204 and the USB Type C interface 206.

It should be noted that in actual application, an existing current used to drive the overvoltage protection switch 204 and the transfer switch 205 is small. Therefore, to make the HEMT device compatible with an existing drive circuit, it is usually required that a gate leakage current of the HEMT device is extremely small and the gate has a high withstand voltage, so that the foregoing system architecture can normally drive the HEMT device. In addition, a threshold voltage of the HEMT device needs to be kept between 1 V and 3 V In other words, characteristics such as the threshold voltage and an on resistance of the HEMT device in the foregoing system architecture are close to those of a conventional p-type gallium nitride HEMT device of a same size. In addition, a specific voltage withstand capability is required between the source S and the gate G and between the drain D and the gate G of the HEMT device, to ensure that the HEMT device does not have a device reliability problem caused by device breakdown.

In addition, the foregoing system architecture may be applied to a scenario in which a handheld electronic device is charged, for example, may be applied to a scenario in which a mobile phone or a tablet computer is charged. An application scenario of the foregoing system architecture is not limited in embodiments of this application.

In addition, the HEMT device provided in embodiments of this application may be applied not only to the foregoing system architecture, but also to a system architecture for charging an energy product or a wireless switch product. For example, the HEMT device may be applicable to a scenario in which a terminal adapter is charged. A system architecture and a scenario to which the HEMT device is applied are not limited in embodiments of this application.

Further, in actual application, the HEMT device may be packaged by using a wafer-level chip scale package (WLCSP) process to obtain a packaged HEMT device. Correspondingly, the packaged HEMT device may be applied to the foregoing system architecture as an overvoltage protection switch or a transfer switch.

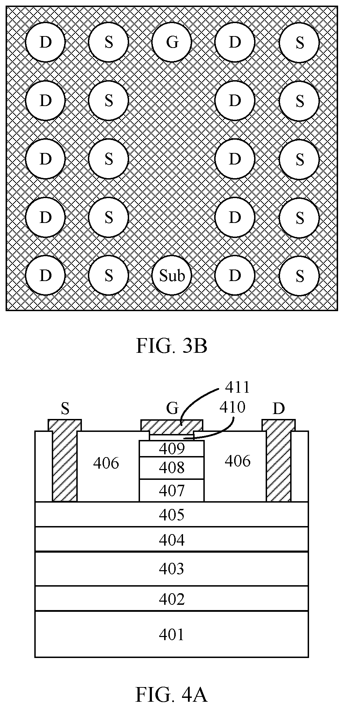

Refer to FIG. 3A and FIG. 3B. FIG. 3A is a schematic diagram of a packaged device according to an embodiment of this application. FIG. 3B is a simplified schematic diagram of arrangement of surface-implanted balls of the packaged device. As shown in FIG. 3A, the packaged device may include, from bottom to top, a back coating 301 and a semiconductor layer 302 including device feature structures. The device feature structures in the semiconductor layer 302 may form a HEMT device, so that power consumption of the packaged device can be reduced on a basis that the HEMT device can reduce a gate leakage current.

In addition, surface-implanted balls 303 are disposed on a surface that is of the semiconductor layer 302 that is opposite to the back coating 301. The surface-implanted balls 303 may be connected to a gate, a source, or a drain of the HEMT device through an under-bump metallization (under-bump metallization, UBM) layer and an interconnection metal layer in the semiconductor layer 302. For details about how the surface-implanted balls 303 are connected to the semiconductor layer 302, refer to implementation in the conventional technology.

For example, a height of the packaged device may be approximately 0.5 mm (millimeter). A thickness of the back coating 301 is approximately 0.04 mm. A thickness of the semiconductor layer 302 is approximately 0.25 mm. A height of the surface-implanted ball 303 is approximately 0.2 mm. The height of the packaged device is only half of a height of an existing plastic-packaged device. In addition, a thermal resistance of the packaged device is approximately 30 degrees Celsius per watt (°C/W). A heat dissipation effect of the packaged device is better than that of a plastic-packaged device of a same size.

In addition, refer to FIG. 3B. FIG. 3B shows 2 mm*2 mm 25-ball arrangement. The surface-implanted balls 303 use a 5*5 arrangement manner. Distribution of the surface-implanted balls 303 is set to reduce a parasitic resistance between backend interconnection metal and the HEMT device. Specifically, from left to right, a first column represents surface-implanted balls 303 (D) corresponding to the drain of the HEMT device, and a second column represents surface-implanted balls 303 (S) corresponding to the source of the HEMT device. In a third column, only surface-implanted balls 303 in a first row and a fifth row are retained. The first row of the third column is a surface-implanted ball 303 (G) corresponding to the gate of the HEMT device. The fifth row of the third column is a surface-implanted ball 303 (Sub) corresponding to a substrate of the HEMT device. Similar to the first column and the second column, a fourth column represents surface-implanted balls 303 (D) corresponding to the drain of the HEMT device, and a fifth column represents surface-implanted balls 303 (S) corresponding to the source of the HEMT device.

In addition, the HEMT device is disposed in the semiconductor layer 302. The semiconductor layer 302 may include, from bottom to top, the substrate, a gallium nitride epitaxial layer, the source of the HEMT device, the drain of the HEMT device, the gate of the HEMT device, a substrate electrode of the HEMT device, an insulation passivation layer, the interconnection metal layer, an intermediate dielectric layer, the UBM layer, and the like. The gallium nitride epitaxial layer, the source of the HEMT device, the drain of the HEMT device, the gate of the HEMT device, and the substrate electrode of the HEMT device are configured to generate the feature structures of the HEMT device. In addition, the generated HEMT device may be generated based on a Si substrate. The insulation passivation layer is configured to passivate a surface of a barrier layer, so that electrical insulation is formed between the source, drain, gate, and substrate electrode of the HEMT device. The interconnection metal layer is configured to connect the electrodes of the HEMT device, the UBM layer, and the surface-implanted balls 303. The UBM layer is configured to dispose the surface-implanted balls 303.

Further, a large quantity of periodically arranged micron-scale HEMT devices may be disposed in the semiconductor layer 302. Each HEMT device may include a gate, a drain, a source, and a substrate electrode. The gate, source, drain, and substrate electrode of each HEMT device may be connected to the UBM layer through the interconnection metal layer, to be connected to the surface-implanted balls 303 through the UBM layer.

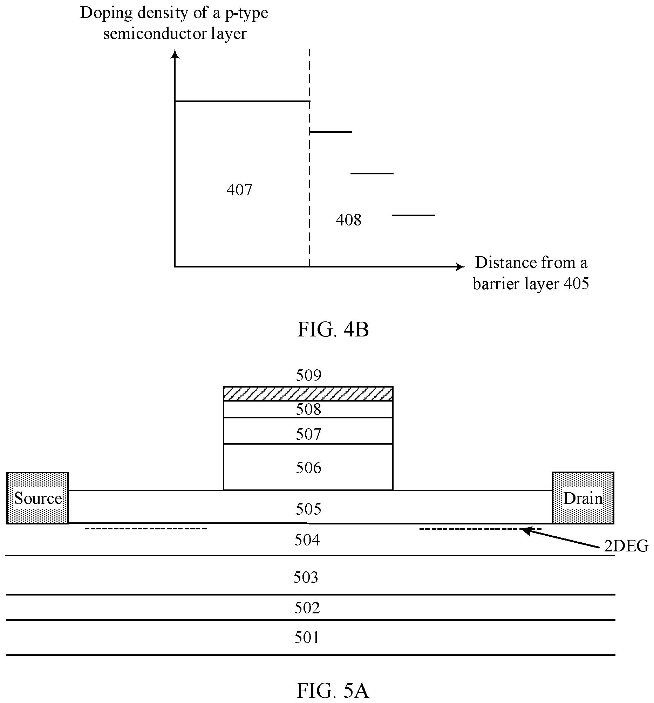

Based on the system architecture and the packaged device related to the HEMT device, in view of a HEMT device shown in FIG. 1, a HEMT device that can reduce a gate leakage current and increase a gate withstand voltage is proposed in the conventional technology. Refer to FIG. 4A and FIG. 4B. FIG. 4A is a schematic diagram of a structure of a HEMT device according to an embodiment of this application. FIG. 4B is a schematic diagram of doping density distribution of a gate p-type layer in a HEMT device according to an embodiment of this application. As shown in FIG. 4A, the HEMT device may include, from bottom to top, a substrate layer 401, a transition layer 402, a buffer layer 403, a channel layer 404, a barrier layer 405, and a gate G, a source S, and a drain D disposed on the barrier layer. The HEMT device may further include a passivation layer 406 disposed on the barrier layer, between the source and the gate, and between the drain and the gate. The gate G may include, from bottom to top, a first p-type semiconductor layer 407, a second p-type semiconductor layer 408, an n-type semiconductor layer 409, and a gate dielectric layer 410. Further, a gate metal layer 411 is disposed on the gate dielectric layer 410.

A doping density of the first p-type semiconductor layer 407 is shown on the left side of FIG. 4B. A doping density of the second p-type semiconductor layer 408 is shown on the right side of FIG. 4B. The doping density of the first p-type semiconductor layer 407 is kept uniform, and is greater than a maximum doping density of the second p-type semiconductor layer 409 whose doping density gradiently decreases.

However, although the HEMT device shown in FIG. 4A can reduce the gate leakage current of the HEMT device, the HEMT device has great impact on characteristic parameters such as a threshold voltage, a transconductance, and an on impedance of the HEMT device, and further affects a switching characteristic and a conduction loss of the HEMT device.

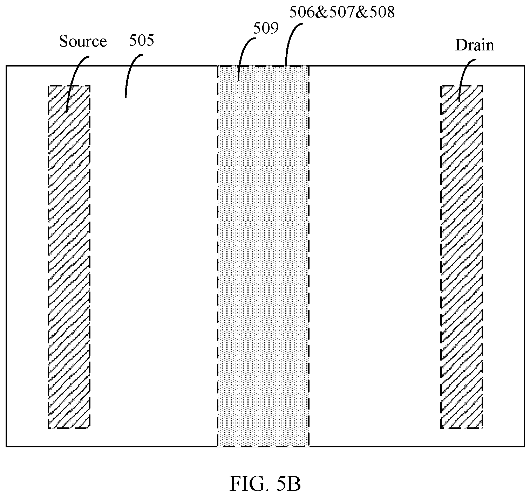

In view of the foregoing problem, an embodiment of this application provides a HEMT device that can reduce a gate leakage current and increase a gate withstand voltage. Refer to FIG. 5A and FIG. 5B. FIG. 5A is a schematic sectional view of a HEMT device according to an embodiment of this application. FIG. 5B is a schematic top view of a HEMT device according to an embodiment of this application. As shown in FIG. 5A, the HEMT device may include, from bottom to top, a substrate 501, a nucleation layer 502 epitaxially disposed on the substrate 501, a buffer layer 503 epitaxially disposed on the nucleation layer 501, a channel layer 504 epitaxially disposed on the buffer layer 503, and a barrier layer 505 epitaxially disposed on the channel layer 504.

The substrate 501 may be made of a material such as Si, sapphire, or silicon carbide (SiC). The nucleation layer 502 may be made of AlN (aluminum nitride). The buffer layer 503 may be made of AlGaN or high-impedance GaN. The channel layer 504 may be made of unintentionally doped GaN. The barrier layer 505 may be made of AlGaN or an aluminide nitride such as indium aluminum nitride (InAlN), so that a heterojunction can be formed with the channel layer 504.

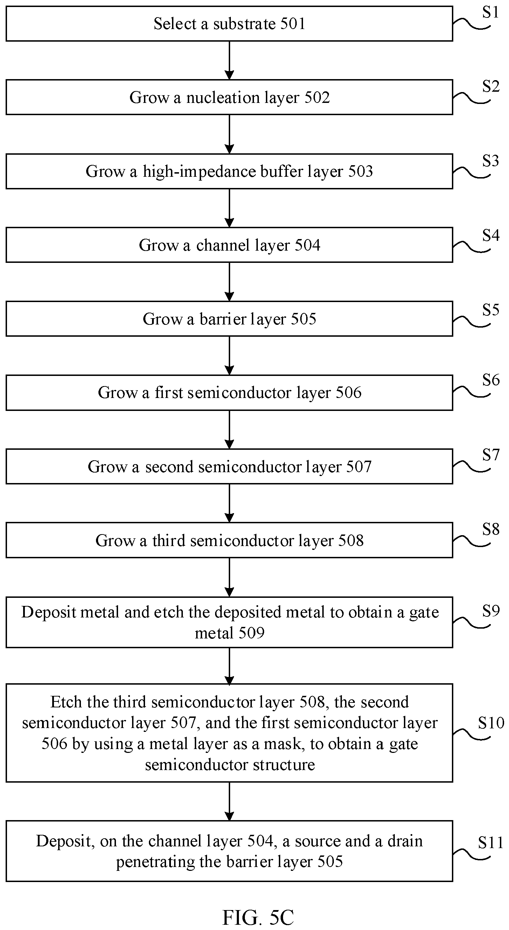

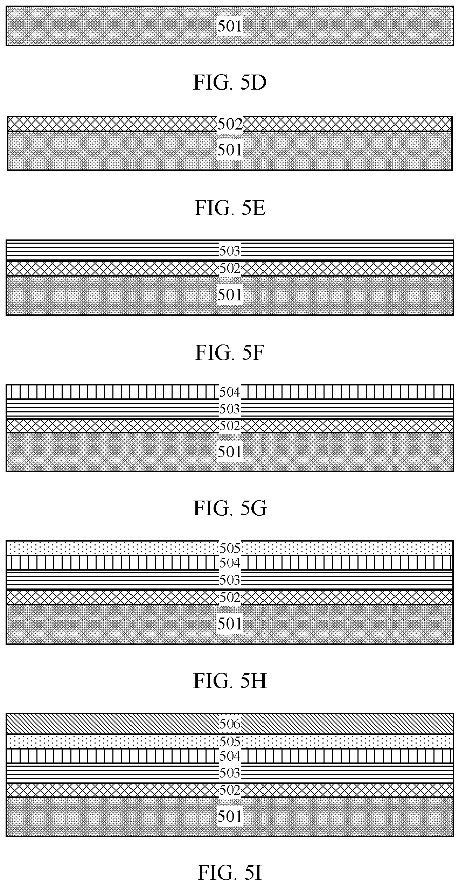

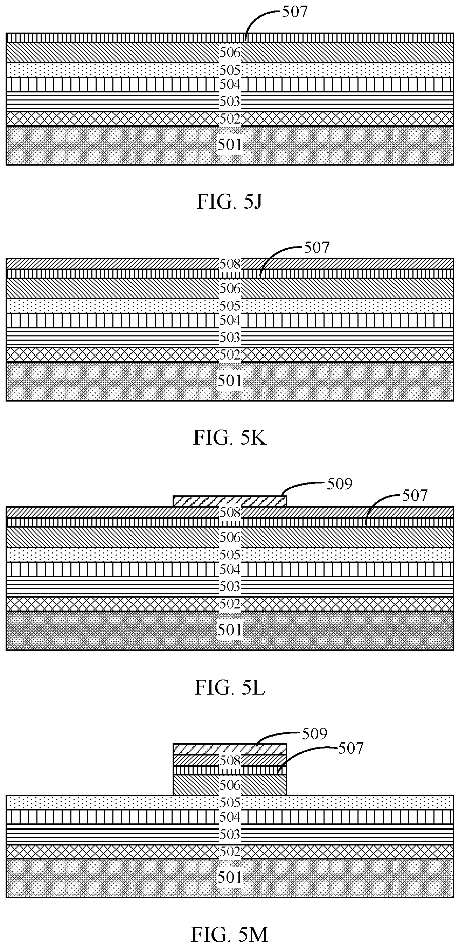

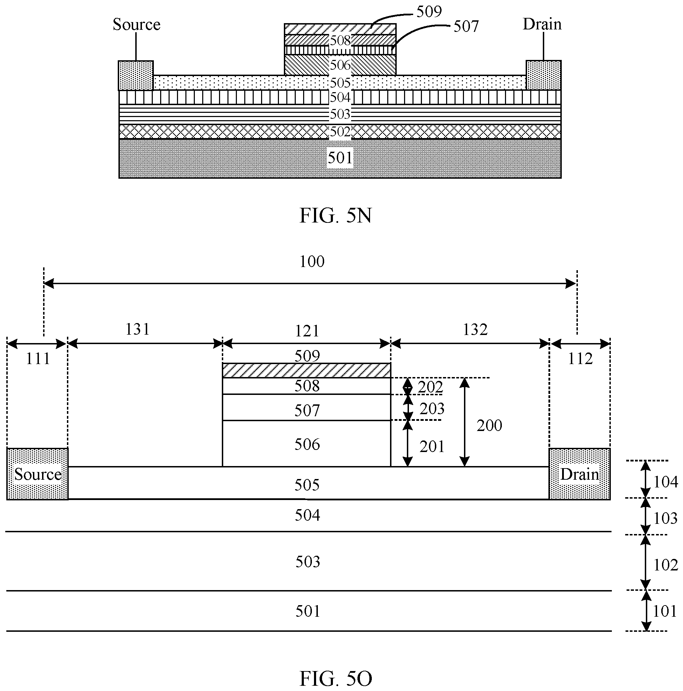

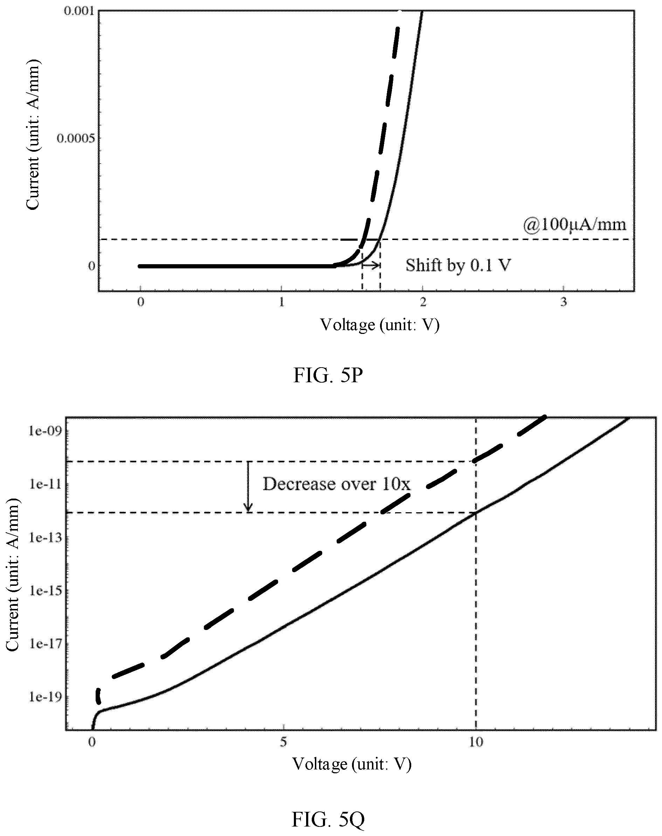

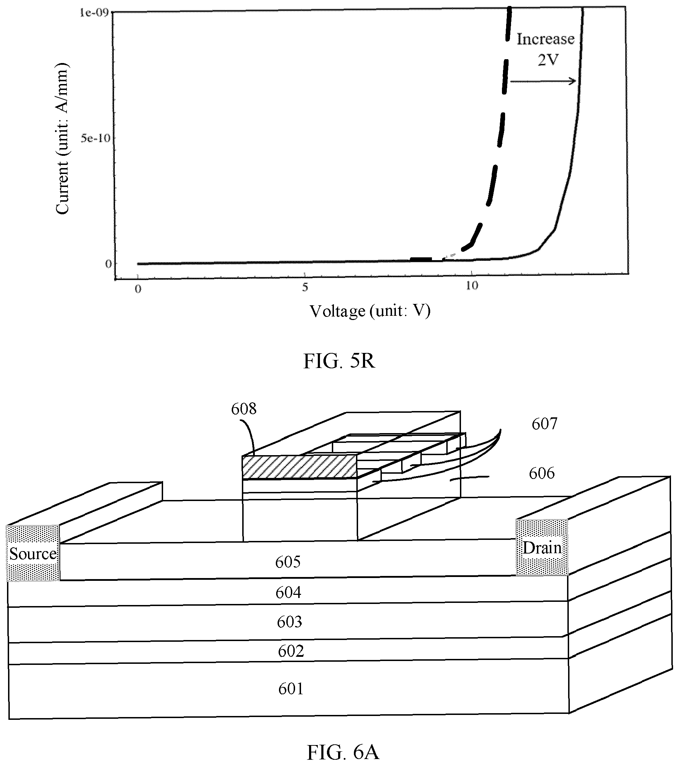

In addition, the nucleation layer 502, the buffer layer 503, the channel layer 504, and the barrier layer 505 of the HEMT device shown in FIG. 5 may constitute a nitride epitaxial layer of the HEMT device. The nitride epitaxial layer may be a nitride epitaxial layer made of an III-V nitride.

It should be noted that the channel layer 504 and the barrier layer 505 may induce a large quantity of polarization charges at the heterojunction under impact of a spontaneous polarization electric field and a piezoelectric polarization electric field, to generate a large quantity of free electrons on a side of the channel layer 504. The generated free electrons are bound in a potential well at the heterojunction due to energy band bending caused by the polarization electric field, to form high-density surface charges, namely, two-dimensional electron gas (two-dimensional electron gas, 2DEG), at a heterojunction interface.

In addition, the barrier layer 505 may include, from bottom to top, a gate semiconductor structure composed of a first semiconductor layer 506, a second semiconductor layer 507, and a third semiconductor layer 508, and a gate metal 509 disposed on the gate semiconductor structure. The first semiconductor layer 506 and the third semiconductor layer 508 may be made of a p-type nitride to form a p-type semiconductor layer. The gate metal 509 and the third semiconductor layer 508 in the gate semiconductor structure may be in ohmic contact or Schottky contact.

The first semiconductor layer 506, the second semiconductor layer 507, or the third semiconductor layer 508 may be made of a nitride such as GaN, AlGaN, indium gallium nitride (InGaN), InAlN, or indium aluminum gallium nitride (InAlGaN). This is not limited in this embodiment of this application. For example, the first semiconductor layer 506 may be made of AlₓGa₁₋ₓN, where 0 ≤ x ≤ 1. In addition, a p-type doping density of the first semiconductor layer 506 may range from 1e17 cm⁻³ to 1e20 cm⁻³. In other words, 10¹⁷ to 10²⁰ particles may be doped in the first semiconductor layer 506 per cubic centimeter. The doped particles may be magnesium (Mg), zinc (Zn), calcium (Ca), carbon (C), or the like. Similarly, the third semiconductor layer 508 may also be made of Al_{z}Ga_{1-z}N, where 0 ≤ z ≤ 1. A p-type doping density ranges from 1e15 cm⁻³ to 1e20 cm⁻³. Doped particles may also be Mg, Zn, Ca, C, or the like. In addition, the second semiconductor layer 507 may also be made of Al_{y}Ga_{1-y}N, where 0 ≤ y ≤ 1. However, doped particles of the second semiconductor layer 507 may be other particles such as Si or germanium (Ge). An n-type doping density may range from 1e15 cm⁻³ to 1e20 cm⁻³. In addition, a doping manner of the second semiconductor layer 507 may be uniformity, gradual change, or gradient change. The doping manner of the second semiconductor layer 507 is not limited in this embodiment of this application. For example, in a direction from the first semiconductor layer 506 to the third semiconductor layer 508, the doping density of the second semiconductor layer 507 may change from small to large, change from large to small, or change from small to large and then to small. The gradual change of the doping density is not limited in this embodiment of this application. However, the second semiconductor layer 507 may alternatively be unintentionally doped. Whether the second semiconductor layer 507 is doped is not limited in this embodiment of this application.

In addition, the HEMT device may further include a source (Source) and a drain (Drain). Contact materials of the source and the drain may be titanium (Ti), titanium nitride (TiN), Al, tantalum (Ta), or the like. As shown in FIG. 5A and FIG. 5B, the source and the drain of the HEMT device may be distributed on two sides of a gate. In addition, the source and the drain may penetrate the barrier layer 505, or may not penetrate the barrier layer 505. FIG. 5A merely shows an example in which the source and the drain penetrate the barrier layer.

Certainly, the source and the drain may be symmetrically distributed on the two sides of the gate semiconductor structure, or may be asymmetrically distributed on the two sides of the gate semiconductor structure.

FIG. 5B merely shows an example in which the source and the drain are symmetrically distributed. This is not limited in this embodiment of this application.

Further, as shown in FIG. 5B, the first semiconductor layer 506, the second semiconductor layer 507, the third semiconductor layer 508, and the gate metal 509 are disposed on the barrier layer 505. The first semiconductor layer 506, the second semiconductor layer 507, and the third semiconductor layer 508 have a same pattern size. Only the barrier layer 505, the gate metal 509 covering the third semiconductor layer 508, and the source and the drain distributed on the two sides of the gate semiconductor structure can be seen in FIG. 5B.

The HEMT device may be manufactured by using a conventional wafer technology. In other words, an epitaxial structure of the HEMT device may be first prepared, and then a device structure of the HEMT device may be prepared on the prepared epitaxial structure to obtain the HEMT device shown in FIG. 5A and FIG. 5B.

Specifically, in a process of preparing the HEMT device, as shown in FIG. 5C, the HEMT device may be manufactured by using the following feasible preparation solution. In steps 1 to 8 of the preparation solution, epitaxial layers of the HEMT device may be generated on the substrate by using an epitaxial process. In steps 9 to 11, some of the epitaxial layers may be etched by using an etching technology, and a metal is deposited, to form the HEMT device.

Specifically, in step 1, as shown in FIG. 5D, the substrate 501 is selected. For example, a Si substrate 501 may be selected. In step 2, as shown in FIG. 5E, the nucleation layer 502 may be generated on the substrate 501 shown in FIG. 5D. The nucleation layer 502 may be made of AlN. In step 3, as shown in FIG. 5F, the buffer layer 503 may be generated on the nucleation layer 502 shown in FIG. 5E. The buffer layer 503 may be made of AlGaN or high-resistance GaN. In step 4, as shown in FIG. 5G, the channel layer 504 may be generated on the buffer layer 503 shown in FIG. 5F. The channel layer 504 may be made of unintentionally doped GaN. In step 5, as shown in FIG. 5H, the barrier layer 505 may be generated on the buffer layer 503 shown in FIG. 5G. The barrier layer 505 may be made of AlGaN. In step 6, as shown in FIG. 5I, the p-type doped first semiconductor layer 506 is generated on the barrier layer 505 shown in FIG. 5H. In step 7, as shown in FIG. 5J, the second semiconductor layer 507 is generated on the first semiconductor layer 506 shown in FIG. 5I. In step 8, as shown in FIG. 5K, the third semiconductor layer 508 is generated on the second semiconductor layer 507 shown in FIG. 5J.

Then, the gate metal 509 may be generated on a second p-type semiconductor by using a deposition technology. The gate metal 509, the third semiconductor layer 508, the second semiconductor layer 507, and the first semiconductor layer 506 are etched by using the etching technology to form a PNP gate structure. Finally, a metal may be deposited to generate the source and the drain.

Specifically, in step 9, as shown in FIG. 5L, a metal may be deposited on the third semiconductor layer 508 shown in FIG. 5K. The deposited metal is etched based on a preset pattern consistent with a PNP gate to obtain the gate metal 509 shown in FIG. 5L. In step 10, as shown in FIG. 5M, the third semiconductor layer 508, the second semiconductor layer 507, and the first semiconductor layer 506 may be etched by using the gate metal 509 as a mask, to obtain a PNP gate semiconductor structure shown in FIG. 5M. In step 11, as shown in FIG. 5N, after the gate semiconductor structure is formed, a metal is deposited on the two sides of the gate semiconductor structure shown in FIG. 5M. A source pattern and a drain pattern are formed through photoetching, and a source structure and a drain structure are formed by using an annealing process.

To further verify an effect of the HEMT device provided in this embodiment of this application, simulation software may be used to simulate the HEMT device provided in this embodiment of this application and a HEMT device with a conventional p-type GaN gate structure. Reduction in a gate leakage current and increase in a gate withstand voltage of the HEMT device provided in this application are determined.

In a simulation process, the HEMT device may be set based on sizes shown in Table 1. For reference numerals in Table 1, refer to FIG. 5O. FIG. 5O shows reference numerals corresponding to structures in the HEMT device. Table 1 shows sizes corresponding to the reference numerals. As shown in FIG. 5O and Table 1, a thickness 101 of the substrate 501 may be 10 micrometers (µm). A thickness 102 of the buffer layer 503 may be 2 µm. A thickness 103 of the channel layer 504 may be 30 nanometers (nm). A thickness 104 of the barrier layer 505 may be 16 nm. A percentage of an Al component at the barrier layer 505 may be 18%.

In addition, a thickness 200 of the PNP gate structure may be 150 nm. A thickness 201 of the first semiconductor layer 506 may be 100 nm, and the doping density may be 3^{∗}10¹⁷ cm⁻³. A thickness 202 of the third semiconductor layer 508 may be 20 nm, and the doping density may be 3^{∗}10¹⁷ cm⁻³. A thickness 203 of the second semiconductor layer 507 may be 30 nm, and the doping density may be 1^{∗}10¹⁷ cm⁻³.

In addition, for the entire HEMT device, a size of a transverse cell 100 of the HEMT device may be 2.5 µm. A length 111 of the source and a length 112 of the drain may both be 0.5 µm. A length 121 of the gate may be 1 µm. A distance 131 between a boundary of the gate semiconductor structure and a boundary of the source may be 0.5 µm. If the source and the drain are symmetrically distributed on the two sides of the gate semiconductor structure, a distance 132 between a boundary of the gate semiconductor structure and a boundary of the drain may be 0.5 µm.

**Table 1**

| Reference numeral | Structure name | Parameter value | Reference numeral | Structure name | Parameter value |
|---|---|---|---|---|---|
| 100 | Size of the cell | 2.5 µm | 202 | Thickness of the third semiconductor layer | 20 nm |
| 101 | Thickness of the substrate | 10 µm | 203 | Thickness of the second semiconductor layer | 30 nm |
| 102 | Thickness of the buffer layer | 2 µm | 111 | Length of the source | 0.5 µm |
| 103 | Thickness of the channel layer | 30 nm | 112 | Length of the drain | 0.5 µm |
| 104 | Thickness of the barrier layer | 16 nm | 121 | Length of the gate | 1 µm |
| 200 | Thickness of the PNP gate structure | 150 nm | 131 | Distance between the gate and source | 0.5 µm |
| 201 | Thickness of the first semiconductor layer | 100 nm | 132 | Distance between the gate and drain | 0.5 µm |

It should be noted that in a simulation experiment, the buffer layer and the nucleation layer may be regarded as a same epitaxial layer. In this case, the nucleation layer may not be disposed, and simulation may be performed by disposing only the buffer layer. Therefore, neither Table 1 nor FIG. 5O includes a size corresponding to the nucleation layer. In addition, in actual application, the foregoing sizes corresponding to the HEMT device may be adjusted based on a performance requirement of the HEMT device. Sizes of the HEMT device are not limited in this embodiment of this application.

First, a threshold voltage may be simulated to determine whether the HEMT device provided in this embodiment of this application has a severe voltage drift, resulting in impact on performance of the HEMT device. When the substrate 501 and the source are at a low level, a drain level is fixed as 0.1 V, and a gate voltage is gradually increased from 0 V In addition, in a process of increasing the gate voltage, a drain current is detected to determine whether the HEMT device is turned on. It may be considered that when the drain current reaches 100 µA/mm (microamperes per millimeter), the HEMT device is turned on. Refer to FIG. 5P. FIG. 5P shows a threshold voltage curve (shown by a dashed line in FIG. 5P) of a conventional HEMT device and a threshold voltage curve (shown by a solid line in FIG. 5P) of the HEMT device provided in this embodiment of this application. As shown in FIG. 5P, when a gate voltage of the conventional HEMT device reaches 1.55 V, the device is turned on. The HEMT device provided in this application is turned on when a gate voltage reaches 1.65 V, and has a drift of only 0.1 V compared with the conventional HEMT device.

Therefore, it can be determined that the threshold voltage of the HEMT device provided in this embodiment of this application slightly changes, and there is little impact on a characteristic parameter such as the threshold voltage of the HEMT device. In addition, the threshold voltage may be adjusted by adjusting a thickness, a doping density, a position, and the like of an n-type semiconductor layer.

Then, simulation tests may be performed on a gate leakage current and a gate withstand voltage of the HEMT device. A low-potential voltage may be provided for the substrate 501, the source, and the drain, and a gate potential is gradually increased from 0 V In addition, in a process of increasing the gate potential, a gate leakage current may be monitored.

Refer to FIG. 5Q. FIG. 5Q shows change curves of the gate leakage currents. As shown in FIG. 5Q, the gate leakage current continuously increases as the gate potential increases. A dashed line in FIG. 5Q is the curve of the gate leakage current of the conventional HEMT device. A solid line in FIG. 5Q is the curve of the gate leakage current of the HEMT device provided in this embodiment of this application. It can be learned from the figure that when the gates have a same voltage, compared with the gate leakage current of the conventional HEMT device, the gate leakage current of the HEMT device provided in this embodiment of this application decreases by 10 times (for example, when the gate voltage is 10 V, the gate leakage current decreases from 10⁻¹⁰ A/mm to 2^{∗}10⁻¹² A/mm), and the gate leakage current of the HEMT device is greatly suppressed.

Refer to FIG. 5R. FIG. 5R shows change curves of gate withstand voltages. As shown in FIG. 5R, the gate leakage current continuously increases as the gate potential increases. A dashed line in FIG. 5R is a curve of a gate leakage current of a conventional p-type HEMT device. A solid line in FIG. 5R is the curve of the gate leakage current of the HEMT device provided in this embodiment of this application. When the gate leakage current reaches 10⁻⁹ A/mm, it may be considered that the gate of the HEMT device is broken down. A gate voltage corresponding to the gate leakage current of 10⁻⁹ A/mm may be used as the gate withstand voltage. It can be learned from the figure that when the gate leakage current reaches 10⁻⁹ A/mm, the gate withstand voltage of the HEMT device provided in this embodiment of this application is increased by 2 V compared with the gate withstand voltage of the conventional HEMT device.

In conclusion, in the HEMT device provided in this embodiment of this application, the nitride PNP structure is disposed on the barrier layer, so that the n-type semiconductor layer in the PNP structure can interact with two adjacent p-type semiconductor layers to form a positive space charge region in an n-type semiconductor region, to repel holes in the gate metal from entering the gate PNP structure. In this way, the gate leakage current is reduced. In addition, when the gate is at a high level, the positive space charge region can reduce an interfacial electric field between the gate metal and the p-type semiconductor layer, to reduce a probability of carrier transition between the gate metal and the gate semiconductor structure. In this way, the gate leakage current of the HEMT device is reduced, and reliability of the HEMT device is improved.

In addition, the first semiconductor layer in the PNP structure is in contact with the barrier layer. Induced negative polarization charges in the first semiconductor layer may supplement positive polarization charges in the barrier layer and the channel layer. Therefore, a density of two-dimensional electron gas in the channel layer can be reduced, so that the HEMT device can be normally off.

In addition, compared with the HEMT device shown in FIG. 4A, the HEMT device provided in this embodiment of this application uses a PNP junction having an n-type buried layer as a gate structure. Through interaction of the first semiconductor layer, the second semiconductor layer, and the third semiconductor layer, the space charge region can be formed, electric field distribution of the gate can be improved, and the probability of the carrier transition between the gate metal and the gate semiconductor structure can be reduced, so that the gate leakage current is reduced and the gate withstand voltage is increased. In addition, in the HEMT device provided in this embodiment of this application, a conventional metal layer is in contact with the third semiconductor layer, and there is no intermediate insulation dielectric layer. Therefore, impact on characteristic parameters such as the threshold voltage and an on resistance of the device is small.

Further, in the HEMT device provided in this embodiment of this application, the first semiconductor layer is disposed on the barrier layer, so that two-dimensional electron gas in a channel below the gate can be effectively exhausted, to form the normally-off HEMT device. In addition, in the gate semiconductor structure of the HEMT device provided in this embodiment of this application, only the second semiconductor layer is an n-type semiconductor layer. An epitaxial process required to manufacture the HEMT device is simple, and impact on the threshold voltage of the HEMT device is small.

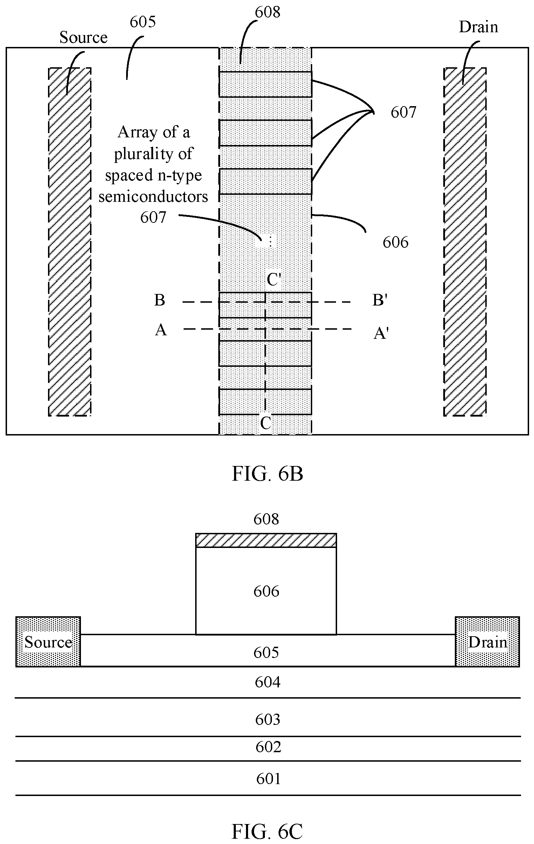

In view of the HEMT device shown in FIG. 1, an embodiment of this application provides a HEMT device with a graphical gate to reduce a gate leakage current and increase a gate withstand voltage. Refer to FIG. 6A and FIG. 6B. FIG. 6A is a schematic diagram of a structure of a HEMT device with a graphical gate according to an embodiment of this application. FIG. 6B is a schematic top view of a HEMT device according to an embodiment of this application. As shown in FIG. 6A, the HEMT device may include, from bottom to top, a substrate 601, a nucleation layer 602 epitaxially disposed on the substrate, a buffer layer 603 epitaxially disposed on the nucleation layer, a channel layer 604 epitaxially disposed on the buffer layer, and a barrier layer 605 epitaxially disposed on the channel layer.

The substrate 601 may be made of a material such as Si, sapphire, or SiC. The nucleation layer 602, the buffer layer 603, the channel layer 604, and the barrier layer 605 may constitute a nitride epitaxial layer. The nitride epitaxial layer is similar to the nitride epitaxial layer of the HEMT device in FIG. 5A. Details are not described herein again.

In addition, the barrier layer 605 may further include, from bottom to top, a graphical super gate structure composed of a first semiconductor layer 606 and a plurality of n-type semiconductors 607, and a gate metal 608 disposed on the graphical super gate. The first semiconductor layer 606 may be made of a p-type nitride to form a p-type semiconductor layer. The gate metal 608 covers the top of the first semiconductor layer 606 and the plurality of n-type semiconductors 607. A contact type may be Schottky contact or ohmic contact. This is not limited in this embodiment of this application.

In addition, the first semiconductor layer 606 may include a plurality of first protrusion portions. The plurality of n-type semiconductors 607 may be disposed in the first semiconductor layer 606. Every two of the n-type semiconductors 607 may be separated by the first protrusion portion. The plurality of first protrusion portions are disposed, so that the gate metal 608 is in contact with the first protrusion portions. That is, the gate metal is in contact with p-type semiconductors. This can reduce impact of the plurality of n-type semiconductors 607 on a characteristic of the HEMT device. In addition, the plurality of first protrusion portions and the plurality of n-type semiconductors 607 may form transverse PN junctions in a horizontal direction. Carriers in each first protrusion portion may be exhausted by using the n-type semiconductors on two sides of the first protrusion portion. In this way, a leakage current in a gate semiconductor structure can be reduced.

The plurality of n-type semiconductors 607 are arranged in a gate width direction, that is, alternately arranged in a C-C' direction shown in FIG. 6B. The n-type semiconductors 607 and the first protrusion portions of the first semiconductor layer 606 are alternately arranged on the top of the first semiconductor layer 606 to form the graphical super gate. In addition, the plurality of n-type semiconductors 607 may be arranged at equal spacings to optimize an electric field and suppress the gate leakage current of the gate semiconductor structure. Certainly, the plurality of n-type semiconductors 607 may alternatively be randomly arranged. A distance between two adjacent n-type semiconductors 607 and an arrangement manner of the n-type semiconductors 607 are not limited in this embodiment of this application.

A surface that is of at least one of the n-type semiconductors 607 and that is close to the gate metal 608 may be coplanar with a surface that is of at least one of the first protrusion portions and that is close to the gate metal 608. In other words, a height of at least one of the first protrusion portions of the first semiconductor layer 606 may be the same as a height of at least one of the n-type semiconductors 607, to form a coplanar gate semiconductor structure, so that an electric field of the gate semiconductor structure can be uniformly distributed, and impact of electric field concentration on an effect of suppressing the gate leakage current is avoided.

The following provides description by using an example in which a surface that is of each n-type semiconductor 607 and that is close to the gate metal 608 is coplanar with a surface that is of each first protrusion portion and that is close to the gate metal 608.

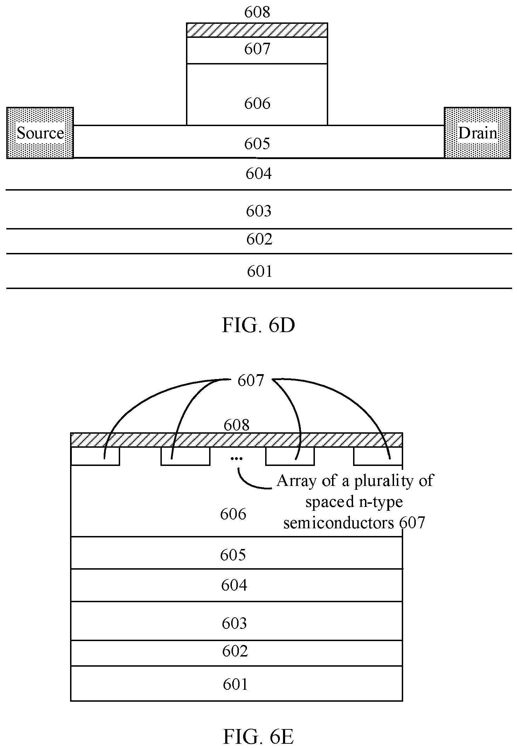

For example, FIG. 6C, FIG. 6D, and FIG. 6E are sectional views of the HEMT device in different directions. FIG. 6C is a sectional view in an A-A' direction in FIG. 6B. It can be learned that the first protrusion portions of the first semiconductor layer 606 are in contact with the gate metal 608. The graphical super gate herein includes only the first semiconductor layer 606, and there are no n-type semiconductors 607. The gate metal 608 covers the first protrusion portions of the first semiconductor layer 606. FIG. 6D is a sectional view in a B-B' direction in FIG. 6B. It can be learned that the graphical super gate herein may include the first semiconductor layer 606 and the n-type semiconductors 607. The n-type semiconductors 607 are on top of the first semiconductor layer 606. The gate metal 608 covers the n-type semiconductors 607. FIG. 6E is a sectional view in the C-C' direction in FIG. 6B. It can be learned that the graphical super gate of the HEMT device may include the first semiconductor layer 606 and the n-type semiconductors 607 wrapped by the first protrusion portions of the first semiconductor layer 606, to form the graphical super gate including an array of the plurality of n-type semiconductors 607 spaced by the plurality of first protrusion portions of the first semiconductor layer 606. The gate metal 608 covers the first protrusion portions of the first semiconductor layer 606 and the n-type semiconductors 607.

It should be noted that both the first semiconductor layer 606 and the n-type semiconductors 607 may be made of a nitride such as GaN, AlGaN, InGaN, InAlN, or InAlGaN. This is not limited in this embodiment of this application. For example, the first semiconductor layer 606 may be made of AlₓGa₁₋ₓN, where 0 ≤ x ≤ 1, and a doping type is p-type. In addition, doped particles of the first semiconductor layer 606 may be Mg, Zn, Ca, C, or the like. A doping density ranges from 1e17 cm⁻³ to 1e20 cm⁻³. In other words, 10¹⁷ to 10²⁰ particles may be doped in the first semiconductor layer 606 per cubic centimeter.

Although the n-type semiconductors 607 may also be made of Al_{y}Ga_{1-y}N, where 0 ≤ y ≤ 1, a doping type of the n-type semiconductors 607 is n-type. However, doped particles of the n-type semiconductors 607 may be Si, Zn, Ca, C, or the like, and a doping density may range from 1e15 cm⁻³ to 1e20 cm⁻³. In addition, the doping density of the n-type semiconductor 607 may be kept uniform, gradually change, or gradiently change. For a doping manner, refer to the n-type semiconductor 507 in the PNP structure of the HEMT device shown in FIG. 5A. A doping manner of the n-type semiconductor 607 is not limited in this embodiment of this application. In addition, the n-type semiconductor 607 is intentionally doped. However, in actual application, the n-type semiconductor 607 may alternatively be unintentionally doped. Whether the n-type semiconductor 607 is doped is not limited in this embodiment of this application.

In addition, the HEMT device may further include a source (Source) and a drain (Drain). Contact materials of the source and the drain may be Ti, TiN, Al, Ta, or the like. As shown in FIG. 6A and FIG. 6B, the source and the drain of the HEMT device may be distributed on two sides of a gate. In addition, the source and the drain may penetrate the barrier layer 605, or may not penetrate the barrier layer 605. FIG. 6A merely shows an example in which the source and the drain penetrate the barrier layer 605.

Certainly, the source and the drain may be symmetrically distributed on two sides of the graphical super gate structure, or may be asymmetrically distributed on two sides of the graphical super gate structure. FIG. 6A and FIG. 6B merely show an example in which the source and the drain are symmetrically distributed. This is not limited in this embodiment of this application.

Further, as shown in FIG. 6B, the first semiconductor layer 606, the plurality of n-type semiconductors 607, and the gate metal 608 are disposed on the barrier layer 605. The plurality of n-type semiconductors 607 are all separated by the plurality of first protrusion portions included in the first semiconductor layer 606 to form the graphical super gate. The gate metal 608 may cover the graphical super gate. Correspondingly, only the barrier layer 605, the gate metal 608, the source, and the drain can be seen in FIG. 6B.

The HEMT device may be manufactured by using a conventional wafer technology. In other words, an epitaxial structure of the HEMT device may be first prepared, and then a device structure of the HEMT device may be prepared on the prepared epitaxial structure to obtain the HEMT device shown in FIG. 6A to FIG. 6E.

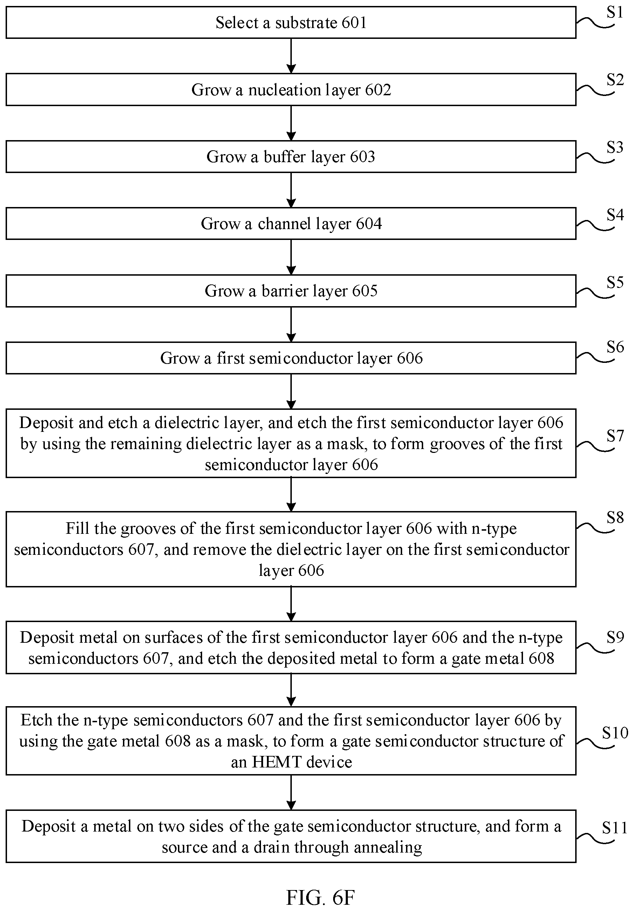

Specifically, in a process of preparing the HEMT device, as shown in FIG. 6F, the HEMT device may be manufactured by using the following feasible preparation solution. In steps 1 to 8 of the preparation solution, epitaxial layers of the HEMT device may be generated on the substrate by using an epitaxial process. In steps 9 to 11, some of the epitaxial layers may be etched by using an etching technology, and a metal is deposited, to form the HEMT device.

Steps 1 to 6 in this embodiment of this application are similar to the steps shown in FIG. 5D to FIG. 5I. Details are not described herein again.

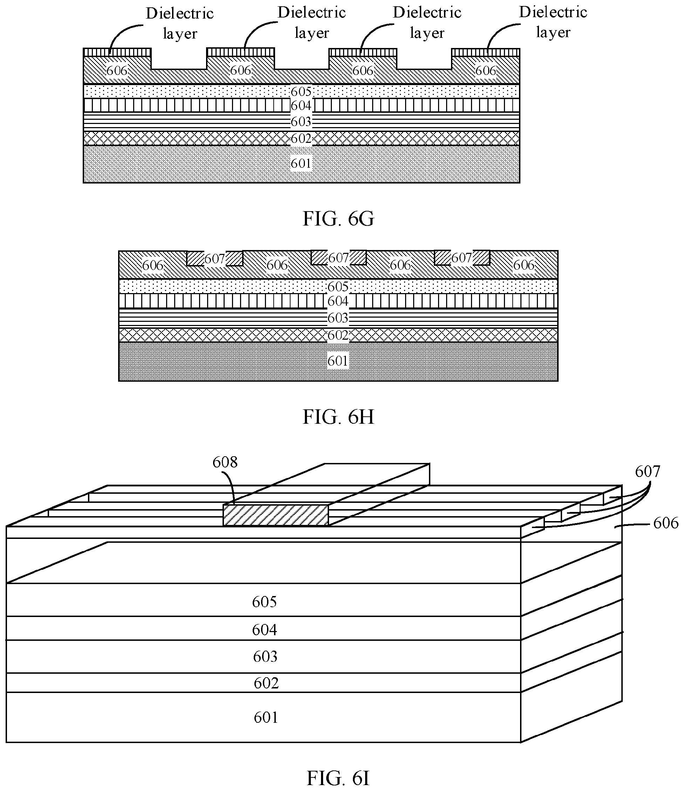

After the first semiconductor layer 606 is generated, step 7 may be performed. As shown in FIG. 6G, a dielectric layer (Dielectric Layer, DL) is deposited on the first semiconductor layer 606, and the dielectric layer is etched based on a preset pattern. After the dielectric layer is etched, partial shallow etching may continue to be performed on the first semiconductor layer 606 by using the remaining dielectric layer as a mask, to form the first protrusion portions of the first semiconductor layer 606.

For example, the dielectric layer and the first semiconductor layer 606 may be etched in the B-B' direction shown in FIG. 6B. A material of the dielectric layer may be an insulation material such as silicon oxide or silicon nitride. The material of the dielectric layer is not limited in this embodiment of this application.

In step 8, as shown in FIG. 6H, space between the plurality of first protrusion portions of the first semiconductor layer 606 shown in FIG. 6G is filled with the n-type semiconductors 607 by using an epitaxial technology, and the dielectric layer on the first semiconductor layer 606 is removed.

In step 9, as shown in FIG. 6I, a metal is deposited on surfaces of the first semiconductor layer 606 and the n-type semiconductors 607 shown in FIG. 6H, and the deposited metal is etched to form the gate metal 608.

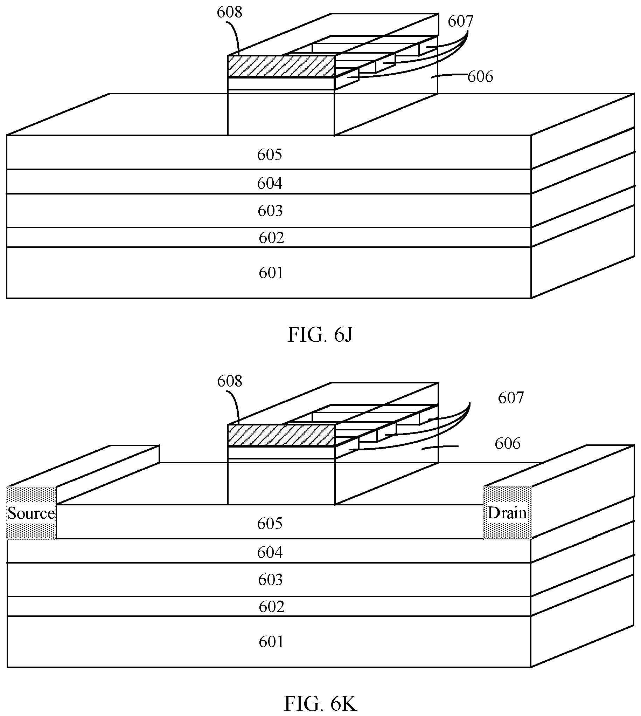

In step 10, as shown in FIG. 6J, the n-type semiconductors 607 and the first semiconductor layer 606 are etched by using the gate metal 608 shown in FIG. 6I as a mask, to form the gate of the HEMT device.

In step 11, as shown in FIG. 6K, a metal is deposited on two sides of the gate shown in FIG. 6J. A source pattern and a drain pattern are formed through photoetching, and a source structure and a drain structure are formed by using an annealing process.

It should be noted that in a process of forming the plurality of n-type semiconductors, the first semiconductor layer 606 may be etched based on the foregoing process of performing steps 7 and 8 to form the first protrusion portions. Then, the space between the plurality of first protrusion portions is epitaxially filled with the n-type semiconductors. Alternatively, the first semiconductor layer 606 may not be etched, but the n-type semiconductors 607 that are alternately arranged are formed by implanting an n-type doping material. The foregoing process is described merely by using an etching and filling manner as an example.

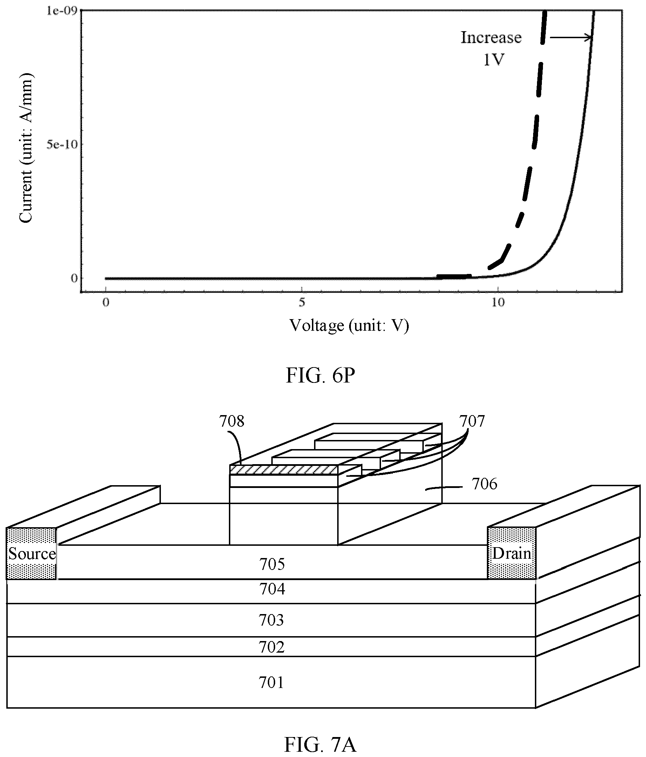

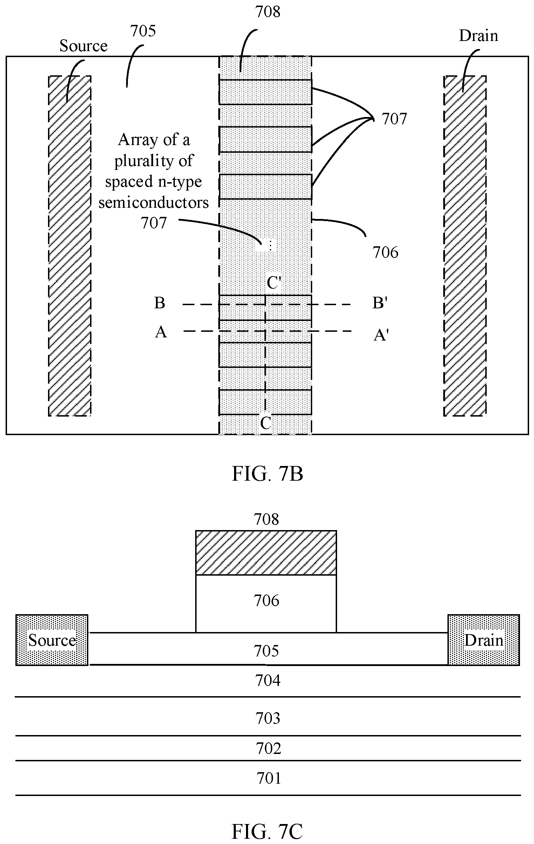

Based on any one of the HEMT devices shown in FIG. 6A to FIG. 6E, an embodiment of this application provides another HEMT device with a graphical gate. Refer to FIG. 7A and FIG. 7B. FIG. 7A is a schematic diagram of a structure of another HEMT device with a graphical gate according to an embodiment of this application. FIG. 7B is a schematic top view of another HEMT device according to an embodiment of this application. As shown in FIG. 7A, the HEMT device may also include, from bottom to top, a substrate 701, a nucleation layer 702, a buffer layer 703, a channel layer 704, and a barrier layer 705.

The substrate 701, the nucleation layer 702, the buffer layer 703, the channel layer 704, and the barrier layer 705 are similar to those of the HEMT device shown in FIG. 6A to FIG. 6E. Details are not described herein again.

However, a plurality of n-type semiconductors 707 of a gate in the HEMT device are arranged on a surface of a first semiconductor layer 706 to form a graphical super gate including the first semiconductor layer 706 and the plurality of n-type semiconductors 707. In addition, space between two adjacent n-type semiconductors 707 may be filled with one of a plurality of second protrusion portions included in a gate metal 708. The space between the plurality of n-type semiconductors does not need to be filled with another material. This can be implemented only by using a metal deposition process. A process of manufacturing the HEMT device can be simplified, and costs of manufacturing the HEMT device can be further reduced. Certainly, the space between the two adjacent n-type semiconductors 707 may alternatively be filled with an insulation dielectric layer to reduce a gate leakage current. Certainly, the space between the plurality of n-type semiconductors 707 may alternatively not be filled with any material. This is not limited in this embodiment of this application.

For ease of description, in this embodiment of this application, only an example in which the space between the two adjacent n-type semiconductors 707 is filled with the gate metal 708 is used for description below.

Specifically, the p-type doped first semiconductor layer 706 may be disposed on the barrier layer of the HEMT device. The plurality of n-type semiconductors 707 are disposed on an upper surface of the first semiconductor layer 706. Finally, the gate metal 708 covers the plurality of n-type semiconductors 707, so that the gate metal 708 is in contact with the n-type semiconductors 707. In addition, the gate metal 708 with which the space between the plurality of n-type semiconductors 707 is filled may be the second protrusion portions of the gate metal 708, so that the gate metal 708 is also in contact with the first semiconductor layer 706.

An arrangement direction of the plurality of n-type semiconductors 707 is perpendicular to a connection line between a source and a drain. In other words, the plurality of n-type semiconductors 707 are arranged in a direction parallel to a gate width direction, namely, a C-C' direction shown in FIG. 7B. In addition, the plurality of n-type semiconductors 707 may be arranged at equal spacings, or may be randomly arranged. A distance between two adjacent n-type semiconductors 707 and an arrangement manner of the n-type semiconductors 707 are not limited in this embodiment of this application.

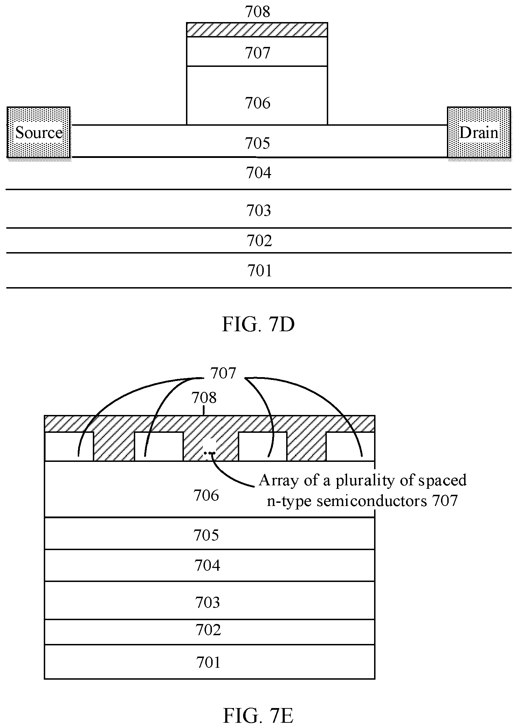

For example, FIG. 7C, FIG. 7D, and FIG. 7E are sectional views of the HEMT device in different directions. FIG. 7C is a sectional view in an A-A' direction in FIG. 7B. It can be seen that the first semiconductor layer 706 is in contact with the second protrusion portions of the gate metal 708. In addition, blocked by the second protrusion portions of the gate metal 708, the n-type semiconductors 707 cannot be seen. FIG. 7D is a sectional view in a B-B' direction in FIG. 7B. It can be seen that the HEMT device includes the first semiconductor layer 706 and the n-type semiconductors 707. The n-type semiconductors 707 are on the upper surface of the first semiconductor layer 706. The gate metal 708 covers the n-type semiconductors 707. FIG. 7E is a sectional view in the C-C' direction in FIG. 7B. It can be seen that the HEMT device includes the first semiconductor layer 706 and the n-type semiconductors 707 arranged at spacings on the upper surface of the first semiconductor layer 706. The graphical super gate including an array of the plurality of spaced n-type semiconductors is formed. The second protrusion portions of the gate metal 708 cover the first semiconductor layer 706. The gate metal 708 covers the n-type semiconductors 707.

It should be noted that for materials, doping types, and doping densities of the first semiconductor layer 706 and the n-type semiconductors 707 in this embodiment of this application, reference may be made to the first semiconductor layer 606 and the n-type semiconductors 607 in the HEMT device shown in FIG. 6A to FIG. 6E. Details are not described herein again. In addition, for gradual change of the doping density of the n-type semiconductors 707, refer to that of the n-type semiconductors 607 in FIG. 6A to FIG. 6E. Details are not described herein again.

In addition, similar to the HEMT device shown in FIG. 6A to FIG. 6E, as shown in FIG. 7A and FIG. 7B, the HEMT device provided in this embodiment of this application may further include a source (Source) and a drain (Drain). Details are not described herein again.

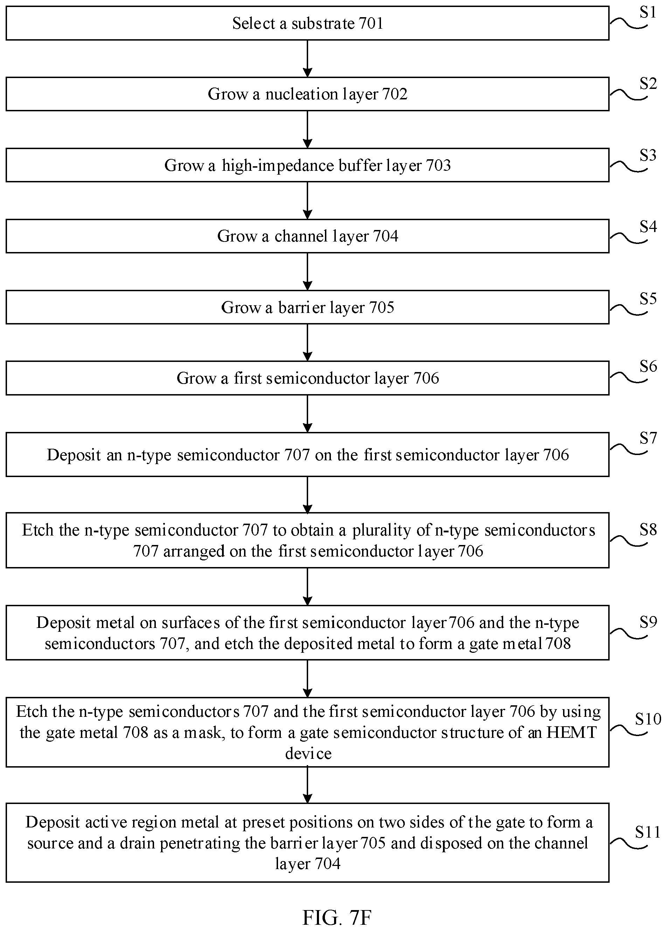

Further, the HEMT device provided in this embodiment of this application may also be manufactured by using a conventional wafer technology. As shown in FIG. 7F, a process is similar to a process corresponding to FIG. 6F. In steps 1 to 6 of a feasible preparation solution, the substrate 701 is also first selected, and then the nucleation layer 702, the buffer layer 703, the channel layer 704, the barrier layer 705, and the first semiconductor layer 706 are epitaxially grown on the substrate 701 in sequence.

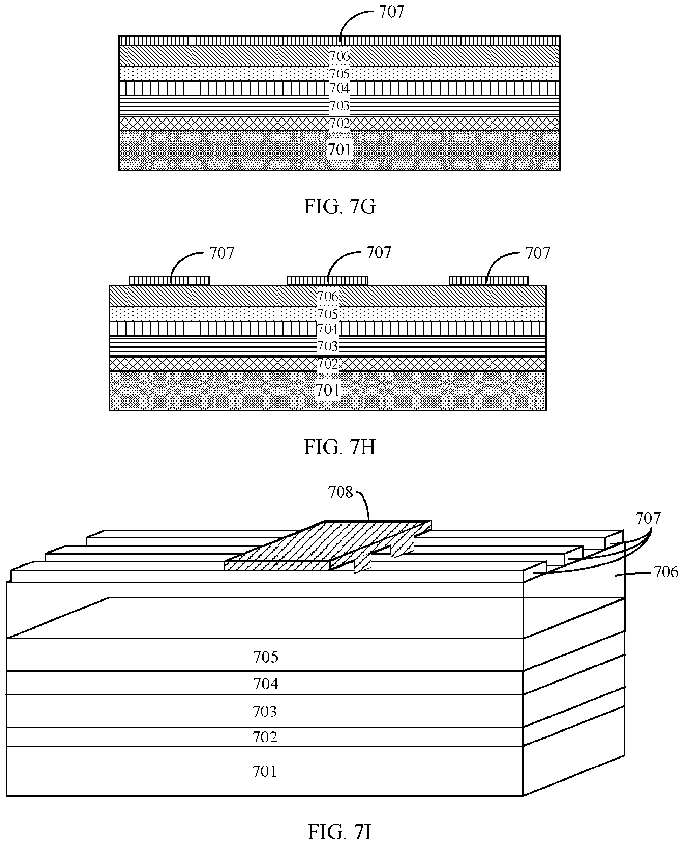

Then, step 7 may be performed. As shown in FIG. 7G, the n-type semiconductors 707 may be deposited on the first semiconductor layer 706.

In step 8, as shown in FIG. 7H, the n-type semiconductors 707 shown in FIG. 7G are etched based on a preset size of an n-type semiconductor layer 707 to obtain the plurality of n-type semiconductors 707 arranged on the first semiconductor layer 706.

In step 9, as shown in FIG. 7I, a metal is deposited on surfaces of the first semiconductor layer 706 and the n-type semiconductors 707 shown in FIG. 7H, and the deposited metal is etched to form the gate metal 708 including the second protrusion portions.

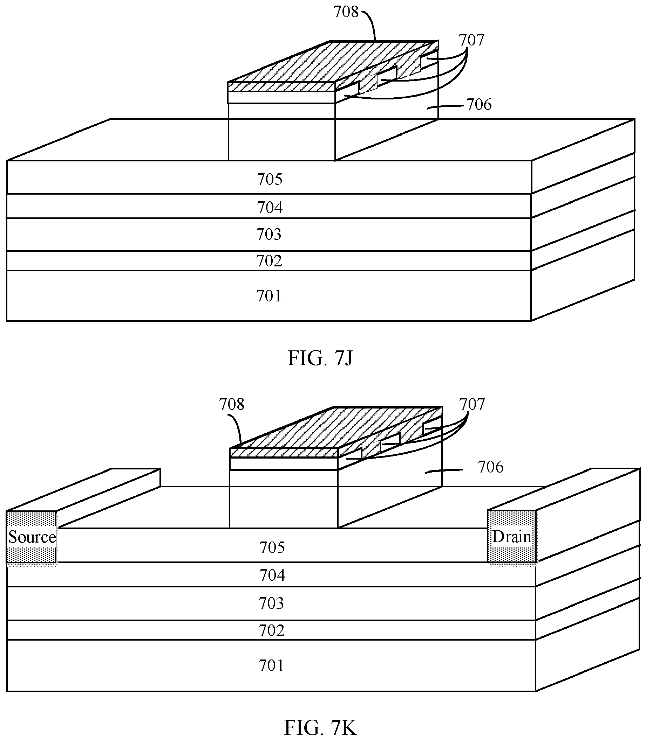

In step 10, as shown in FIG. 7J, the n-type semiconductors 707 and the first semiconductor layer 706 are etched by using the gate metal 708 shown in FIG. 7I as a mask, to form the gate of the HEMT device.

In step 11, as shown in FIG. 7K, a metal is deposited on two sides of the gate shown in FIG. 7J. A source pattern and a drain pattern are formed through photoetching, and a source structure and a drain structure are formed by using an annealing process.

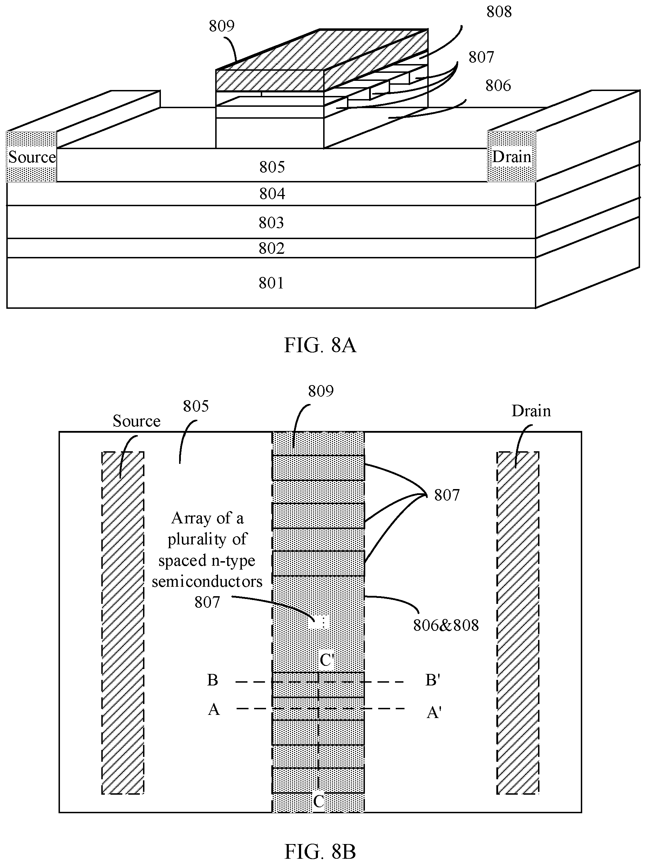

Based on any one of the HEMT devices shown in FIG. 6A to FIG. 6E, an embodiment of this application provides still another HEMT device with a graphical gate. Refer to FIG. 8A and FIG. 8B. FIG. 8A is a schematic diagram of a structure of still another HEMT device with a graphical gate according to an embodiment of this application. FIG. 8B is a schematic top view of still another HEMT device according to an embodiment of this application. As shown in FIG. 8A, the HEMT device may also include, from bottom to top, a substrate 801, a nucleation layer 802, a buffer layer 803, a channel layer 804, and a barrier layer 805.

The substrate 701, the nucleation layer 702, the buffer layer 703, the channel layer 704, and the barrier layer 705 are similar to those of the HEMT device shown in FIG. 6A to FIG. 6E. Details are not described herein again.

However, based on any one of the HEMT devices shown in FIG. 6A to FIG. 6D, in the HEMT device provided in this embodiment of this application, a p-type semiconductor layer is further disposed on a first semiconductor layer 706 and n-type semiconductors 707 of a gate to form a graphical super gate with a PNP structure, so that an electric field of a gate semiconductor structure can be further optimized, and impact of electric field concentration on an effect of suppressing a gate leakage current is avoided. In addition, because an etching process aggravates electric leakage of side walls of the first semiconductor layer 706 and the plurality of n-type semiconductors 707, the electric leakage of the side walls of the first semiconductor layer 706 and the plurality of n-type semiconductors 707 may be avoided by adding the p-type semiconductor layer. In this way, the gate leakage current of the HEMT device is reduced.

Specifically, a graphical super gate including a p-type doped first semiconductor layer 806, n-type semiconductors 807 wrapped by a plurality of first protrusion portions included in the first semiconductor layer 806, and a second semiconductor layer 808 epitaxially generated on top of the first semiconductor layer 806 and the n-type semiconductors 807, and a gate metal 809 disposed on the graphical super gate may be disposed on the barrier layer 805 of the HEMT device.

The gate metal 809 may be in Schottky contact or ohmic contact with the graphical super gate. This is not limited in this embodiment of this application.

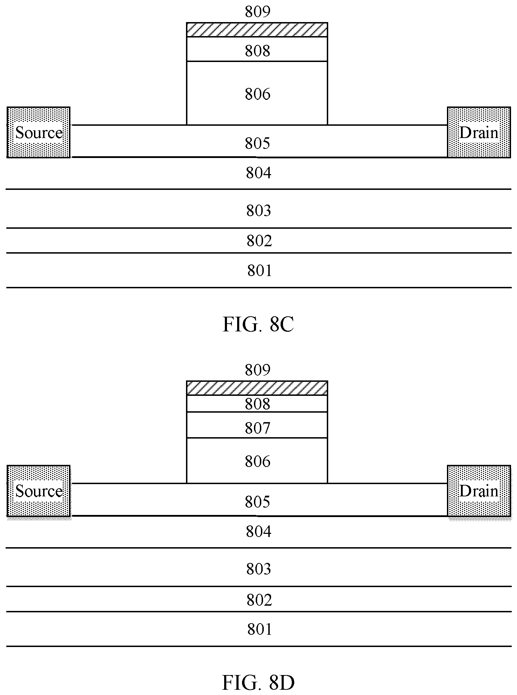

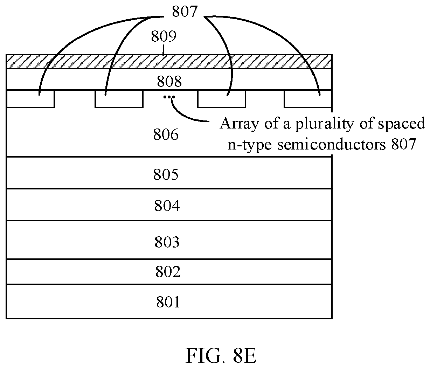

For example, FIG. 8C, FIG. 8D, and FIG. 8E are sectional views of the HEMT device in different directions. FIG. 8C is a sectional view in an A-A' direction in FIG. 8B. It can be seen that the first protrusion portions of the first semiconductor layer 806 are in contact with the second semiconductor layer 808. The second semiconductor layer 808 is in contact with the gate metal 809. The n-type semiconductors 807 blocked by the first protrusion portions of the first semiconductor layer 806 cannot be seen. FIG. 8D is a sectional view in a B-B' direction in FIG. 8B. It can be seen that the graphical super gate of the HEMT device herein includes the first semiconductor layer 806, the n-type semiconductors 807, and the second semiconductor layer 808. The n-type semiconductors 807 cover the top of the first semiconductor layer 806. The second semiconductor layer 808 covers the n-type semiconductors 807. The gate metal 809 covers an upper surface of the second semiconductor layer 808. FIG. 8E is a sectional view in a C-C' direction in FIG. 8B. It can be seen that the graphical super gate of the HEMT device herein includes the first semiconductor layer 806, the n-type semiconductors 807 wrapped by the first protrusion portions of the first semiconductor layer, and the second semiconductor layer 808 to form the graphical super gate including a PNP structure. The gate metal 809 covers the second semiconductor layer 808.

It should be noted that the first semiconductor layer 806, the n-type semiconductors 807, and the second semiconductor layer 808 may all be made of a nitride such as GaN, AlGaN, InGaN, InAlN, or InAlGaN. This is not limited in this embodiment of this application. For doping manners of the first semiconductor layer 806 and the n-type semiconductors 807, refer to the first semiconductor layer 606 and the n-type semiconductors 607 in FIG. 6A to FIG. 6E. Details are not described herein again.

However, the second semiconductor layer 808 may be made of Al_{z}GaN_{1-z}, where 0 ≤ z ≤ 1, and a doping type is p-type. In addition, doped particles may be Mg, Zn, Ca, C, or the like, and a doping density may range from 1e15 cm⁻³ to 1e20 cm⁻³. In addition, the doping density may be kept uniform, gradually change, or gradiently change. For a doping manner, refer to the n-type semiconductor 607 of the gate in FIG. 6A to FIG. 6E.

In addition, the second semiconductor layer 808 may be intentionally doped. However, in actual application, the second semiconductor layer 808 may alternatively be unintentionally doped. Whether the second semiconductor layer 808 is doped is not limited in this embodiment of this application.

In addition, similar to the HEMT device shown in FIG. 6A to FIG. 6E, as shown in FIG. 8A and FIG. 8B, the HEMT device provided in this embodiment of this application may further include a source (Source) and a drain (Drain). Details are not described herein again.

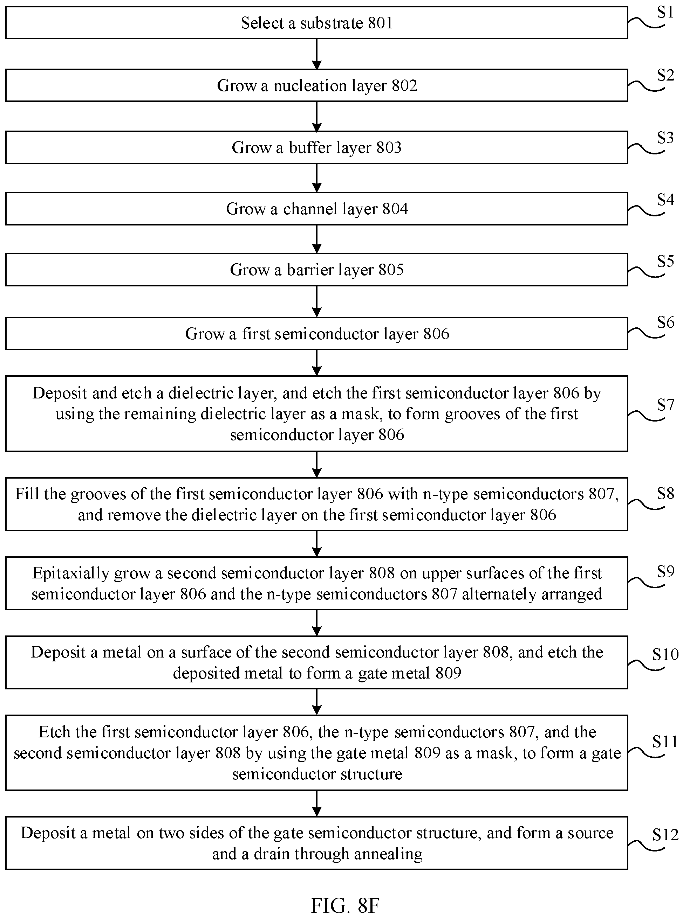

Further, the HEMT device provided in this embodiment of this application may also be manufactured by using a conventional wafer technology. As shown in FIG. 8F, a process is similar to a process corresponding to FIG. 6F. In steps 1 to 8 of a feasible preparation solution, the substrate 801 is also first selected, and then the nucleation layer 802, the buffer layer 803, the channel layer 804, the barrier layer 805, and the first semiconductor layer 806 are epitaxially grown on the substrate 801 in sequence. Then, the first semiconductor layer 806 may be etched. Grooves obtained after the etching are epitaxially filled with the n-type semiconductors 807.

Next, the second semiconductor layer 808 may be epitaxially grown on upper surfaces of the first protrusion portions of the first semiconductor layer 806 and the n-type semiconductors 807 that are alternately arranged, to form an embedded graphical super gate. In a manner shown in FIG. 6I to FIG. 6K, the gate metal 809 is deposited on a surface of the second semiconductor layer 808. The first semiconductor layer 806, the n-type semiconductors 807, and the second semiconductor layer 808 are etched to form a gate semiconductor structure of the HEMT device. Finally, a metal is deposited on two sides of the gate semiconductor structure, a source pattern and a drain pattern are formed through photoetching, and a source structure and a drain structure are formed by using an annealing process.

It should be noted that in a process of forming the plurality of n-type semiconductors 807, the first semiconductor layer 806 may be etched based on the foregoing process of performing step 7 and step 8 to form the plurality of first protrusion portions of the first semiconductor layer 806. Then, the space between the plurality of first protrusion portions is epitaxially filled with the n-type semiconductors 807. Alternatively, the first semiconductor layer 806 may not be etched, but the n-type semiconductors 807 that are alternately arranged are formed by implanting an n-type doping material. The foregoing process is described merely by using an etching and filling manner as an example.

To further verify an effect of the HEMT device provided in this embodiment of this application, simulation software may be used to simulate the HEMT device provided in this embodiment of this application and a HEMT device with a conventional p-type GaN gate structure. Reduction in a gate leakage current and increase in a gate withstand voltage of the HEMT device provided in this application are determined. The following uses simulation of the HEMT device shown in FIG. 6A to FIG. 6E as an example for description.

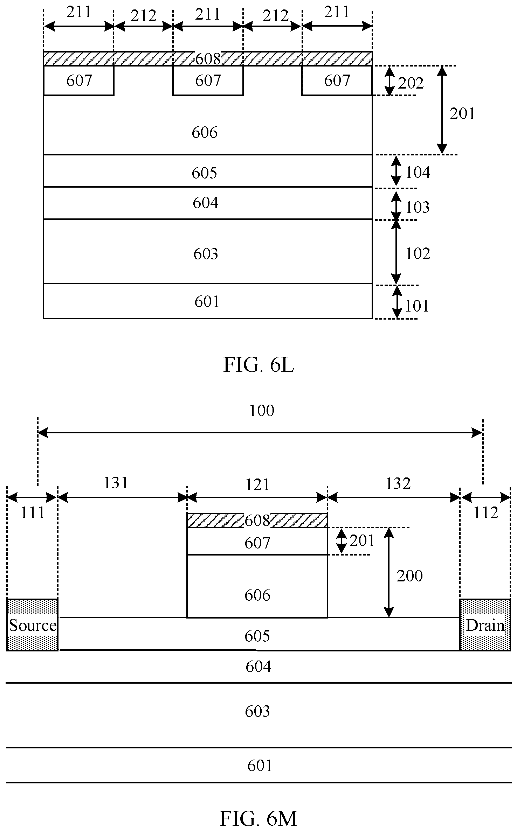

In a process of performing the simulation on the HEMT device, the HEMT device may be set based on sizes shown in Table 2. For reference numerals in Table 2, refer to FIG. 6L and FIG. 6M. FIG. 6L and FIG. 6M show reference numerals corresponding to structures in the HEMT device. Table 2 shows sizes corresponding to the reference numerals. FIG. 6L is a sectional view of the HEMT device shown in FIG. 6A in the C-C' direction shown in FIG. 6B. FIG. 6M is a sectional view of the HEMT device shown in FIG. 6A in the B-B' direction shown in FIG. 6B.

As shown in FIG. 6L, FIG. 6M, and Table 2, a thickness 101 of the substrate 601 may be 10 µm. A thickness 102 of the buffer layer 603 may be 2 µm. A thickness 103 of the channel layer 604 may be 30 nm. A thickness 104 of the barrier layer 605 may be 16 nm. A percentage of an Al component at the barrier layer 605 may be 18%.

In addition, a height 200 of the gate semiconductor structure including the n-type semiconductors 607 and the first semiconductor layer 606 is 150 nm. Because the n-type semiconductors 607 are embedded into grooves of the first semiconductor layer 606, a thickness 201 of the first semiconductor layer 606 is also 150 nm. A thickness 202 of the n-type semiconductor 607 is 50 nm. A doping density of the first semiconductor layer 606 may be 3^{∗}10¹⁷ cm⁻³. A doping density of the n-type semiconductors 607 may be 2^{∗}10¹⁸ cm⁻³.

Further, as shown in FIG. 6L, a width 211 of each n-type semiconductor 607 in the B-B' direction is 0.2 µm. In addition, each n-type semiconductor 607 and the first semiconductor layer 606 are alternately arranged. A distance 212 between a boundary of any n-type semiconductor 607 and a boundary of another adjacent n-type semiconductor 607 is 0.2 µm.

In addition, as shown in FIG. 6M, for the entire HEMT device, a size of a transverse cell 100 of the HEMT device may be 2.5 µm. A length 111 of the source and a length 112 of the drain may both be 0.5 µm. A length 121 of the gate semiconductor structure may be 1 µm. A distance 131 between a boundary of the gate semiconductor structure and a boundary of the source may be 0.5 µm. If the source and the drain are symmetrically distributed on the two sides of the gate, a distance 132 between a boundary of the gate semiconductor structure and a boundary of the drain may be 0.5 µm.

**Table 2**

| Reference numeral | Structure name | Parameter value | Reference numeral | Structure name | Parameter value |
|---|---|---|---|---|---|
| 100 | Size of the cell | 2.5 µm | 211 | Width of the n-type semiconductor | 0.2 µm |
| 101 | Thickness of the substrate | 10 µm | 212 | Distance between two adjacent n-type semiconductors | 0.2 µm |
| 102 | Thickness of the buffer layer | 2 µm | 111 | Length of the source | 0.5 µm |
| 103 | Thickness of the channel layer | 30 nm | 112 | Length of the drain | 0.5 µm |
| 104 | Thickness of the barrier layer | 16 nm | 121 | Length of the gate | 1 µm |
| 201 | Thickness of the first semiconductor layer | 150 nm | 131 | Distance between the gate and source | 0.5 µm |
| 202 | Thickness of the n-type semiconductor | 50 nm | 132 | Distance between the gate and drain | 0.5 µm |

It should be noted that in a simulation experiment, the buffer layer and the nucleation layer may be regarded as a same epitaxial layer. In this case, the nucleation layer may not be disposed, and simulation may be performed by disposing only the buffer layer. Therefore, none of FIG. 6L, FIG. 6M, and Table 2 includes a size corresponding to the nucleation layer. In addition, in actual application, the foregoing sizes corresponding to the HEMT device may be adjusted based on a performance requirement of the HEMT device. Sizes of the HEMT device are not limited in this embodiment of this application.

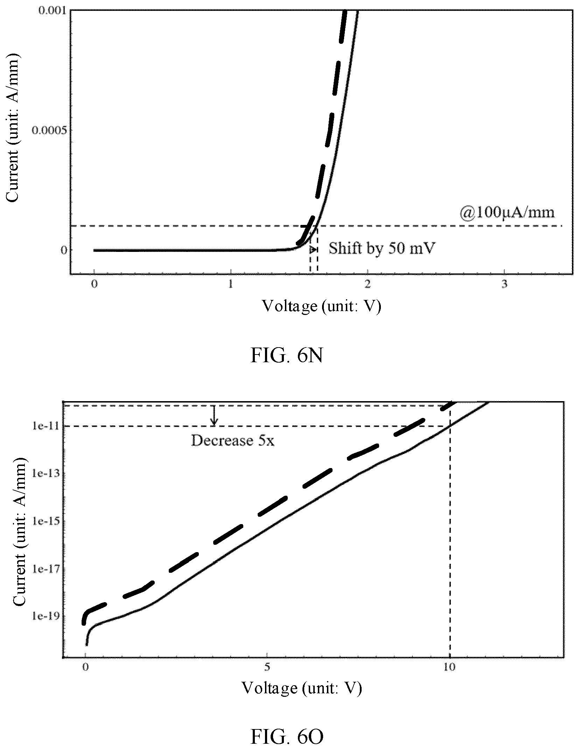

First, a threshold voltage may be simulated to determine whether the HEMT device provided in this embodiment of this application has a severe voltage drift, resulting in impact on performance of the HEMT device. When the substrate and the source are at a low level, a drain level is fixed as 0.1 V, and a gate voltage is gradually increased from 0 V In addition, in a process of increasing the gate voltage, a drain current is detected to determine whether the HEMT device is turned on. It may be considered that when the drain current reaches 100 µA/mm, the HEMT device is turned on. Refer to FIG. 6N. FIG. 6N shows a threshold voltage curve (shown by a dashed line in FIG. 6N) of a conventional HEMT device and a threshold voltage curve (shown by a solid line in FIG. 6N) of the HEMT device provided in this embodiment of this application. As shown in FIG. 6N, when a gate voltage of the conventional HEMT device reaches 1.55 V, the device is turned on. The HEMT device provided in this application is turned on when a gate voltage reaches 1.6 V, and has a drift of only 0.05 V compared with the conventional HEMT device.

Therefore, it can be determined that the threshold voltage of the HEMT device provided in this embodiment of this application slightly changes, and there is little impact on a characteristic parameter such as the threshold voltage of the HEMT device. In addition, the threshold voltage of the HEMT device may be adjusted by adjusting a thickness, a doping density, and the like of an n-type semiconductor layer.

Then, simulation tests may be performed on a gate leakage current and a gate withstand voltage of the HEMT device. A low-potential voltage may be provided for the substrate, the source, and the drain, and a gate potential is gradually increased from 0 V In addition, in a process of increasing the gate potential, a gate leakage current may be monitored.

Refer to FIG. 6O. FIG. 6O shows change curves of the gate leakage currents. As shown in FIG. 6O, the gate leakage current continuously increases as the gate potential increases. A dashed line in FIG. 6O is the curve of the gate leakage current of the conventional p-type HEMT device. A solid line in FIG. 6O is the curve of the gate leakage current of the HEMT device provided in this embodiment of this application. It can be learned from the figure that when the gates have a same voltage, compared with the gate leakage current of the conventional HEMT device, the gate leakage current of the HEMT device provided in this embodiment of this application decreases by five times (for example, when the gate voltage is 10 V, the gate leakage current decreases from 10⁻¹⁰ A/mm to 2^{∗}10⁻¹¹ A/mm), and the gate leakage current of the HEMT device is greatly suppressed.

Refer to FIG. 6P. FIG. 6P shows change curves of gate withstand voltages. As shown in FIG. 6P, the gate leakage current continuously increases as the gate potential increases. A dashed line in FIG. 6P is the curve of the gate leakage current of the conventional HEMT device. A solid line in FIG. 6P is the curve of the gate leakage current of the HEMT device provided in this embodiment of this application. When the gate leakage current reaches 10⁻⁹ A/mm, it may be considered that the gate of the HEMT device is broken down. A gate voltage corresponding to the gate leakage current of 10⁻⁹ A/mm may be used as the gate withstand voltage. It can be learned from the figure that when the gate leakage current reaches 10⁻⁹ A/mm, the gate withstand voltage of the HEMT device provided in this embodiment of this application is increased by 1 V compared with the gate withstand voltage of the conventional HEMT device.

In conclusion, in the HEMT device provided in this embodiment of this application, the first semiconductor layer and the plurality of n-type semiconductors alternately arranged on the surface of the first semiconductor layer are disposed on the barrier layer. Each n-type semiconductor may form a PN junction with the first semiconductor layer that is in contact with the n-type semiconductor. Therefore, electric field distribution between the gate metal and the semiconductors can be adjusted by using a space charge region of the PN junction, to reduce a probability of carrier transition between the gate metal and the gate semiconductor structure. In this way, the gate leakage current of the HEMT device is reduced, and the gate withstand voltage of the HEMT device is increased.

In addition, in comparison with the HEMT device shown in FIG. 5A and FIG. 5B, in the HEMT device provided in this embodiment of this application, in a direction from the barrier layer to the gate metal, as shown in FIG. 6C, the gate structure of the HEMT device may include only the first semiconductor layer. Alternatively, as shown in FIG. 6D, the gate structure of the HEMT device may include both the first semiconductor layer and the n-type semiconductors. Similar to that in structures in FIG. 5A and FIG. 5B, a PN junction is formed by including the first semiconductor layer and an n-type semiconductor region, to reduce the gate leakage current of the HEMT device and increase the gate withstand voltage of the HEMT device. Different from that in the structures in FIG. 5A and FIG. 5B, a characteristic parameter such as a threshold voltage closer to that of a conventional p-type HEMT structure is obtained by using only a region including the first semiconductor layer. Reference is made to a simulation result. Therefore, in this embodiment of this application, impact of the gate semiconductor structure on a characteristic parameter such as the threshold voltage is reduced.

In addition, in this embodiment of this application, a shape and a size of the n-type semiconductor in the gate may be adjusted based on the characteristic parameter of the HEMT device to reduce impact of the n-type semiconductor on a gate electric field, to reduce impact of the n-type semiconductor on the characteristic parameter of the HEMT device.

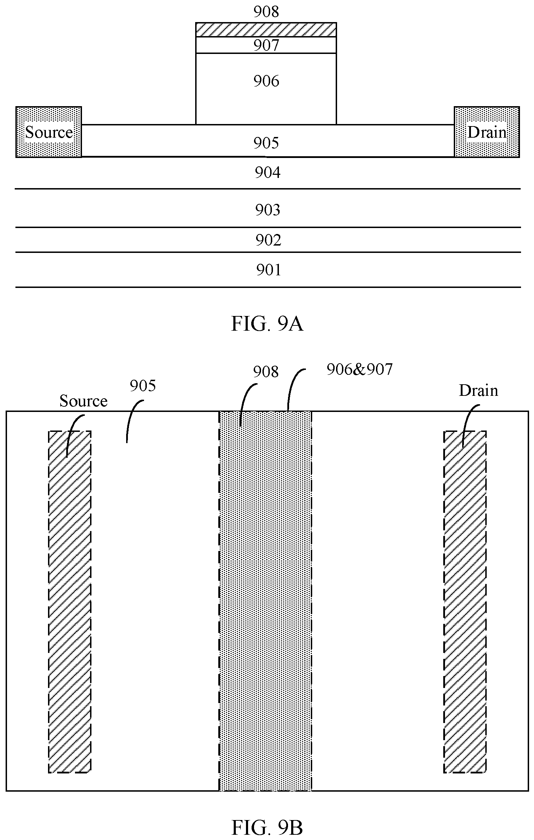

In view of the HEMT device shown in FIG. 1, an embodiment of this application provides another HEMT device based on a change in semiconductor material components of a gate. Refer to FIG. 9A and FIG. 9B. FIG. 9A is a schematic sectional view of another HEMT device according to an embodiment of this application. FIG. 9B is a schematic top view of another HEMT device according to an embodiment of this application. As shown in FIG. 9A, the HEMT device may include, from bottom to top, a substrate 901, a nucleation layer 902 epitaxially disposed on the substrate, a buffer layer 903 epitaxially disposed on the nucleation layer, a channel layer 904 epitaxially disposed on the buffer layer, and a barrier layer 905 epitaxially disposed on the channel layer.

The substrate 901 may be made of a material such as Si, sapphire, or SiC. The nucleation layer 902, the buffer layer 903, the channel layer 904, and the barrier layer 905 may constitute a nitride epitaxial layer. The nitride epitaxial layer is similar to the nitride epitaxial layer of the HEMT device in FIG. 5A. Details are not described herein again.

Different from the HEMT device shown in FIG. 5A to FIG. 5C, the HEMT device provided in this embodiment of this application may further include, from bottom to top, on the barrier layer 905: a gate semiconductor structure including a first semiconductor layer 906 and a second semiconductor layer 907, and a gate metal 908 disposed on a gate semiconductor layer. The first semiconductor layer 906 may be made of a p-type nitride to form a p-type semiconductor layer. The second semiconductor layer 907 may be made of a p-type nitride including an Al component. The gate metal 908 may be in ohmic contact or Schottky contact with the gate semiconductor structure. This is not limited in this embodiment of this application.

The first semiconductor layer 906 may be made of a nitride such as GaN, AlGaN, InGaN, InAlN, or InAlGaN. This is not limited in this embodiment of this application. For example, the first semiconductor layer 906 may be made of p-type GaN or AlₓGa₁₋ₓN with a low percentage of an Al component, where 0 ≤ x ≤ 1. In addition, a doping density of the first semiconductor layer 906 may range from 1e17 cm⁻³ to 1e20 cm⁻³, and doped particles may be Mg, Zn, Ca, C, or the like.

In addition, the second semiconductor layer 907 may be made of an aluminide nitride such as AlGaN, InGaN, InAlN, or InAlGaN. A band gap width of the second semiconductor layer 907 may be greater than a band gap width of the first semiconductor layer 906, or a total polarization intensity of the second semiconductor layer 907 may be greater than a total polarization intensity of the first semiconductor layer 906. For example, the second semiconductor layer 907 may also be made of Al_{y}Ga_{1-y}N, where 0 ≤ x < y ≤ 1. However, a percentage of the Al component at the second semiconductor layer 907 is higher than a percentage of the Al component at the first semiconductor layer 906. In addition, a doping type of the second semiconductor layer 907 may be n-type, p-type, or unintentional doping. This is not limited herein.

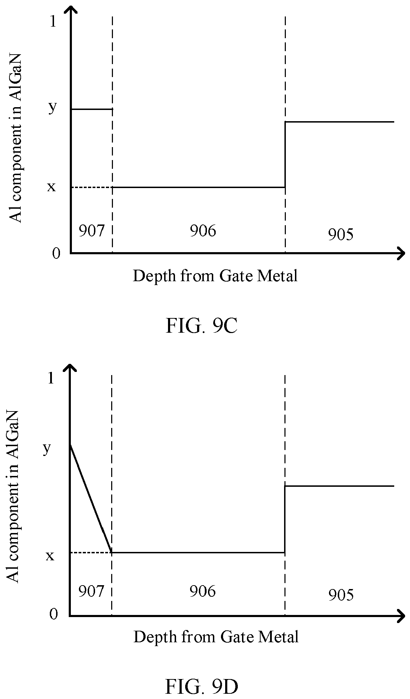

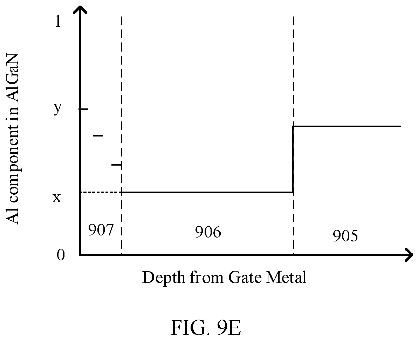

It should be noted that the percentage of the Al component at the second semiconductor layer 907 may be kept uniform, gradually change, or gradiently change. For example, FIG. 9C, FIG. 9D, and FIG. 9E each show a change curve of the Al component at the second semiconductor layer 907, the first semiconductor layer 906, and the barrier layer 905. A horizontal coordinate in the figure indicates a distance from the gate metal 908, and a vertical coordinate indicates a percentage of an Al component.

As shown in FIG. 9C, it can be learned that percentages of Al components in the second semiconductor layer 907, the first semiconductor layer 906, and the barrier layer 905 are sequentially shown from left to right in the figure. A change curve corresponding to the second semiconductor layer 907 is presented as a horizontal line, indicating that the percentage of the Al component at the second semiconductor layer 907 is always maintained as a constant y. The percentage of the Al component at the first semiconductor layer 906 is always maintained as a constant x, where x is less than y. The percentage of the Al component at the barrier layer 905 may be greater than or equal to the percentage x of the Al component at the first semiconductor layer 906, but is irrelevant to the percentage y of the Al component at the second semiconductor layer 907. This is not limited in this embodiment of this application.

As shown in FIG. 9D, it can be learned that the percentage of the Al component at the second semiconductor layer 907 gradually decreases as the distance from the gate metal 908 increases, and the percentage of the Al component decreases from the percentage corresponding to y to the percentage corresponding to x. The Al component at the second semiconductor layer 907 is arranged in a gradual manner. The Al components in the first semiconductor layer 906 and the barrier layer 905 are similar to those in FIG. 9C. Details are not described herein again.

As shown in FIG. 9E, it can be learned that a curve corresponding to the percentage of the Al component of the second semiconductor layer 907 includes a plurality of horizontal short lines. Short lines corresponding to different percentages of Al components correspond to different spacings. As the distance between the second semiconductor layer 907 and the gate metal 908 continuously increases, the percentage of the Al component at the second semiconductor layer 907 continuously decreases. The Al component at the second semiconductor layer 907 is arranged in a gradient manner. For example, as shown in FIG. 9E, the second semiconductor layer 907 includes three different percentages of Al components. A longer distance from the gate metal 908 indicates a lower percentage of the Al component. The Al components in the first semiconductor layer 906 and the barrier layer 905 are similar to those in FIG. 9C. Details are not described herein again.

In addition, a doping type of the second semiconductor layer 907 is not limited in this embodiment of this application. For example, the doping type may be p-type doping, n-type doping, or unintentional doping (Unintentionally doped, UID). This is not limited in this embodiment of this application.

In this embodiment of this application, the aluminum component at the second semiconductor layer 907 is distributed in a uniform, gradual, or gradient manner, so that an electric field peak value of the gate semiconductor structure can be reduced, an electric field can be optimized, and impact of electric field concentration on an effect of suppressing a gate leakage current can be avoided. In addition, in a process of generating the second semiconductor layer 907, a lattice mismatch phenomenon is reduced due to impact of a distribution manner of the aluminum component, so that quality of the generated second semiconductor layer 907 can be improved.

It should be noted that the HEMT device may further include a source and a drain. Contact materials of the source and the drain may be Ti, TiN, Al, Ta, or the like. As shown in FIG. 9A and FIG. 9B, the source and the drain of the HEMT device may be distributed on two sides of the gate semiconductor structure.

Certainly, the source and the drain may be symmetrically distributed on the two sides of the gate semiconductor structure, or may be asymmetrically distributed on the two sides of the gate semiconductor structure. FIG. 9B merely shows an example in which the source and the drain are symmetrically distributed. This is not limited in this embodiment of this application.

The HEMT device may be manufactured by using a conventional wafer technology. In other words, an epitaxial structure of the HEMT device may be first prepared, and then a device structure of the HEMT device may be prepared on the prepared epitaxial structure to obtain the HEMT device shown in FIG. 9A and FIG. 9B.

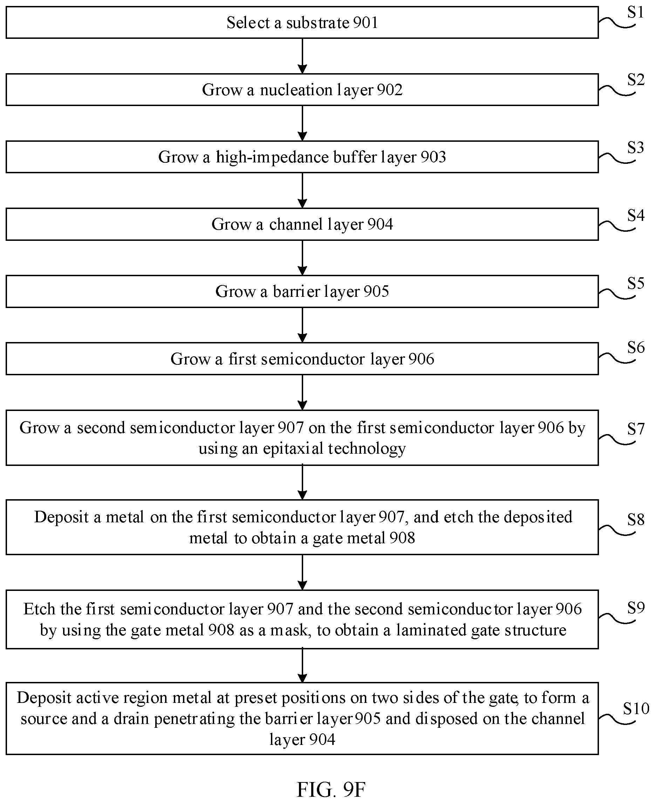

Specifically, in a process of preparing the HEMT device, as shown in FIG. 9F, the HEMT device may be manufactured by using a feasible preparation solution. With reference to FIG. 5D, steps 1 to 6 of preparing the HEMT device in this embodiment of this application are similar to those shown in FIG. 5E to FIG. 5J. Details are not described herein again.

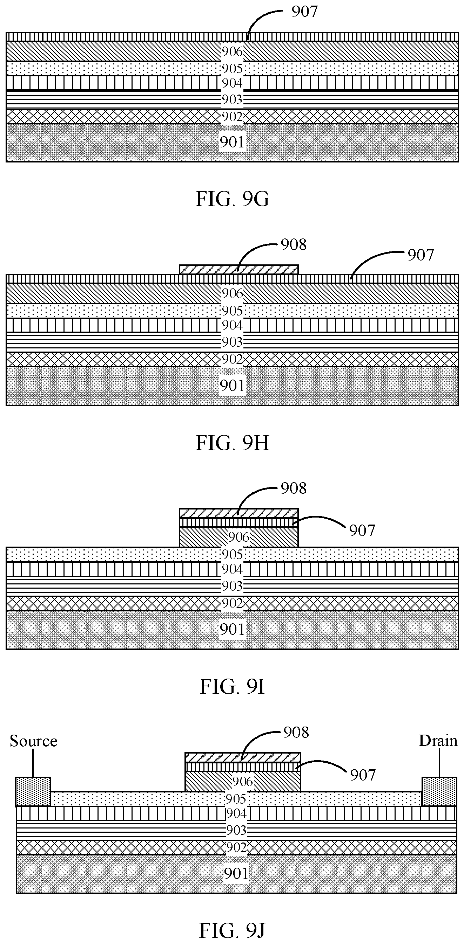

After the first semiconductor layer 906 is generated, step 7 may be performed. As shown in FIG. 9G, the second semiconductor layer 907 is grown on the first semiconductor layer 906 by using an epitaxial technology, so that a complete epitaxial structure of the HEMT device can be formed.

In step 8, as shown in FIG. 9H, a metal is deposited on the second semiconductor layer 907 shown in FIG. 9G, and the deposited metal is etched based on a preset pattern structure to obtain the gate metal 908 shown in FIG. 9H.

In step 9, as shown in FIG. 9I, the second semiconductor layer 907 and the first semiconductor layer 906 may be etched by using the gate metal 908 as a mask, to obtain a laminated gate structure shown in FIG. 9I.

In step 10, as shown in FIG. 9J, a metal is deposited on two sides of the gate shown in FIG. 9I. A source pattern and a drain pattern are formed through photoetching, and a source structure and a drain structure are formed by using an annealing process.

To further verify an effect of the HEMT device provided in this embodiment of this application, simulation software may be used to simulate the HEMT device provided in this embodiment of this application and a HEMT device with a conventional p-type GaN gate structure. Reduction in a gate leakage current and increase in a gate withstand voltage of the HEMT device provided in this application are determined.

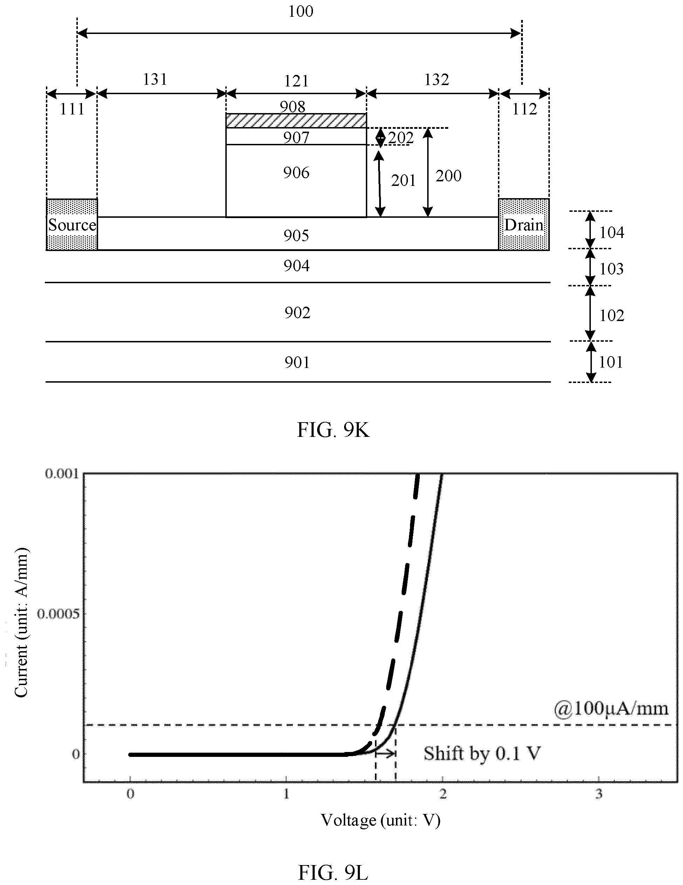

In a simulation process, the HEMT device may be set based on sizes shown in Table 3. For reference numerals in Table 3, refer to FIG. 9K. FIG. 9K shows reference numerals corresponding to structures in the HEMT device. Table 3 shows sizes corresponding to the reference numerals. As shown in FIG. 9K and Table 3, a thickness 101 of the substrate 901 may be 10 µm. A thickness 102 of the buffer layer 903 may be 2 µm. A thickness 103 of the channel layer 904 may be 30 nm. A thickness 104 of the barrier layer 905 may be 16 nm. A percentage of the Al component at the barrier layer 905 may be 18%.

In addition, a thickness 200 of the gate semiconductor structure including the first semiconductor layer 906 and the second semiconductor layer 907 may be 150 nm. A thickness 201 of the first semiconductor layer 906 may be 130 nm, and a doping density may be 3^{∗}10¹⁷ cm⁻³. A thickness 202 of the second semiconductor layer 907 may be 20 nm, a doping density may be 3^{∗}10¹⁷ cm⁻³, a doping type is p-type, and a percentage of the Al component at the second semiconductor layer 907 may be 5%.

In addition, for the entire HEMT device, a size of a transverse cell 100 of the HEMT device may be 2.5 µm. A length 111 of the source and a length 112 of the drain may both be 0.5 µm. A length 121 of the gate may be 1 µm. A distance 131 between a boundary of the gate semiconductor structure and a boundary of the source may be 0.5 µm. If the source and the drain are symmetrically distributed on the two sides of the gate, a distance 132 between a boundary of the gate semiconductor structure and a boundary of the drain may be 0.5 µm.

**Table 3**

| Reference numeral | Structure name | Parameter value | Reference numeral | Structure name | Parameter value |
|---|---|---|---|---|---|
| 100 | Size of the cell | 2.5 µm | 202 | Thickness of the second semiconductor layer | 20 nm |
| 101 | Thickness of the substrate | 10 µm | 111 | Length of the source | 0.5 µm |
| 102 | Thickness of the buffer layer | 2 µm | 112 | Length of the drain | 0.5 µm |
| 103 | Thickness of the channel layer | 30 nm | 121 | Length of the gate | 1 µm |
| 104 | Thickness of the barrier layer | 16 nm | 131 | Distance between the gate and source | 0.5 µm |
| 200 | Thickness of the gate semiconductor structure | 150 nm | 132 | Distance between the gate and drain | 0.5 µm |
| 201 | Thickness of the first semiconductor layer | 120 nm | | | |

It should be noted that in a simulation experiment, the buffer layer and the nucleation layer may be regarded as a same epitaxial layer. In this case, the nucleation layer may not be disposed, and simulation may be performed by disposing only the buffer layer. Therefore, neither FIG. 9K nor Table 3 includes a size corresponding to the nucleation layer. In addition, in actual application, the foregoing sizes corresponding to the HEMT device may be adjusted based on a performance requirement of the HEMT device. Sizes of the HEMT device are not limited in this embodiment of this application.

First, a threshold voltage may be simulated to determine whether the HEMT device provided in this embodiment of this application has a severe voltage drift, resulting in impact on performance of the HEMT device. When the substrate and the source are at a low level, a drain level is fixed as 0.1 V, and a gate voltage is gradually increased from 0 V In addition, in a process of increasing the gate voltage, a drain current is detected to determine whether the HEMT device is turned on. It may be considered that when the drain current reaches 100 µA/mm, the HEMT device is turned on. Refer to FIG. 9L. FIG. 9L shows a threshold voltage curve (shown by a dashed line in FIG. 9L) of a conventional HEMT device and a threshold voltage curve (shown by a solid line in FIG. 9L) of the HEMT device provided in this embodiment of this application. As shown in FIG. 9L, when a gate voltage of the conventional HEMT device reaches 1.55 V, the device is turned on. The HEMT device provided in this application is turned on when a gate voltage reaches 1.65 V, and has a drift of only 0.1 V compared with the conventional HEMT device.

Therefore, it can be determined that the threshold voltage of the HEMT device provided in this embodiment of this application slightly changes, and there is little impact on a characteristic parameter such as the threshold voltage of the HEMT device.

Then, simulation tests may be performed on a gate leakage current and a gate withstand voltage of the HEMT device. A low-potential voltage may be provided for the substrate, the source, and the drain, and a gate potential is gradually increased from 0 V In addition, in a process of increasing the gate potential, a gate leakage current may be monitored.

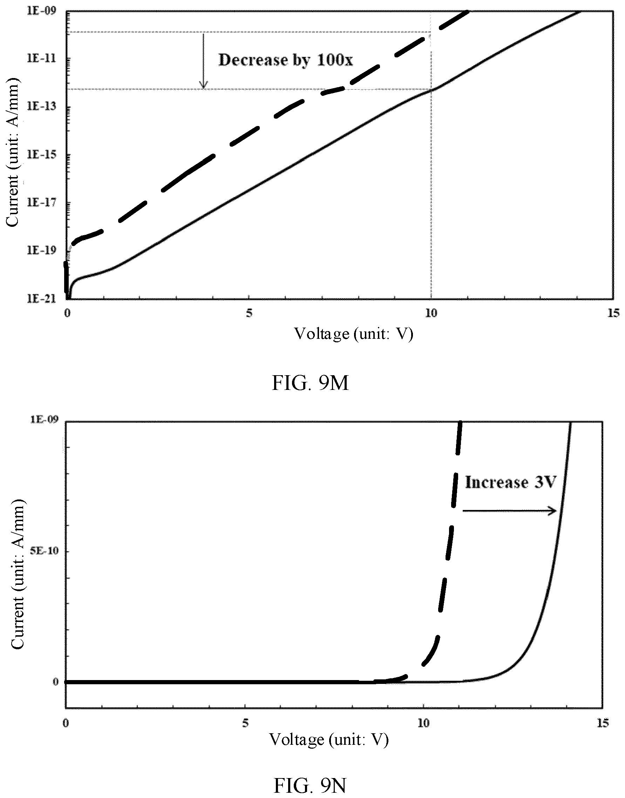

Refer to FIG. 9M. FIG. 9M shows change curves of the gate leakage currents. As shown in FIG. 9M, the gate leakage current continuously increases as the gate potential increases. A dashed line in FIG. 9M is the curve of the gate leakage current of the conventional p-type HEMT device. A solid line in FIG. 9M is the curve of the gate leakage current of the HEMT device provided in this embodiment of this application. It can be learned from the figure that when the gates have a same voltage, compared with the gate leakage current of the conventional HEMT device, the gate leakage current of the HEMT device provided in this embodiment of this application decreases by two orders of magnitude (for example, when the gate voltage is 10 V, the gate leakage current decreases from 10⁻¹⁰ A/mm to 10⁻¹³ A/mm), and the gate leakage current of the HEMT device is greatly suppressed.

Refer to FIG. 9N. FIG. 9N shows change curves of gate withstand voltages. As shown in FIG. 9N, the gate leakage current continuously increases as the gate potential increases. A dashed line in FIG. 9N is the curve of the gate leakage current of the conventional HEMT device. A solid line in FIG. 9N is the curve of the gate leakage current of the HEMT device provided in this embodiment of this application. When the gate leakage current reaches 10⁻⁹ A/mm, it may be considered that the gate of the HEMT device is broken down. A gate voltage corresponding to the gate leakage current of 10⁻⁹ A/mm may be used as the gate withstand voltage. It can be learned from the figure that when the gate leakage current reaches 10⁻⁹ A/mm, the gate withstand voltage of the HEMT device provided in this embodiment of this application is increased by 3 V compared with the gate withstand voltage of the conventional HEMT device.

In conclusion, in the HEMT device provided in this embodiment of this application, the HEMT device with the laminated gate structure is disposed on the barrier layer, so that a band gap width of a part closer to the gate metal increases. Therefore, a Schottky barrier height between the metal and a semiconductor is increased. To be specific, a Schottky barrier height between the gate metal and the second semiconductor layer is increased. A probability of carrier transition between the gate metal and the second semiconductor layer is reduced. In addition, the total polarization intensity of the second semiconductor layer is greater than that of the first semiconductor layer. In this way, by introducing positive polarization charges into the second semiconductor layer, an electric field at an interface between the gate metal and the second semiconductor layer can be adjusted, the probability of the carrier transition between the gate metal and the second semiconductor layer is further reduced, the gate leakage current of the HEMT device is reduced, and the withstand voltage of the gate semiconductor structure is increased.

In addition, if the first semiconductor layer on a surface of the barrier layer is made of GaN or a material with a low percentage of an Al component, the first semiconductor layer is more likely to form a p-type doping region, and can generate tension stress on the barrier layer. A piezoelectric polarization effect of a heterojunction formed by the barrier layer and the channel layer is reduced, so that two-dimensional electron gas below the gate in a groove layer can be effectively exhausted, the HEMT device is more likely to be normally off, and characteristic parameters, such as the threshold voltage, similar to those of the conventional p-type HEMT device can be obtained.

In addition, the second semiconductor layer is made of AlGaN. In other words, a material of the second semiconductor layer may also be a p-type semiconductor material. In this case, the gate metal is in contact with the second semiconductor layer. In other words, the metal is in contact with the p-type semiconductor material. There is no insulation dielectric between the metal and the p-type semiconductor, so that the gate has little impact on characteristic parameters such as the threshold voltage and an on resistance of the HEMT device.

It may be clearly understood by a person skilled in the art that, for the purpose of convenient and brief description, division into the foregoing function units or modules is merely used as an example for illustration. In actual application, the foregoing functions may be allocated to different function units or modules and implemented according to a requirement, that is, an inner structure of an apparatus is divided into different function units or modules to implement all or some of the functions described above. Functional units or modules in the embodiments may be integrated into one processing unit, or each of the units may exist alone physically, or two or more units are integrated into one unit. The integrated unit may be implemented in a form of hardware or a software functional unit. In addition, specific names of the functional units or modules are merely provided for the purpose of distinguishing the units or modules from one another, but are not intended to limit the protection scope of this application. For a detailed working process of the units or modules in the foregoing system, refer to a corresponding process in the foregoing method embodiments. Details are not described herein again.

In the foregoing embodiments, the description of each embodiment has respective focuses. For a part that is not described in detail in an embodiment, refer to related descriptions in other embodiments.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

In the embodiments provided in this application, it should be understood that the disclosed HEMT device, HEMT device manufacturing method, wafer, packaged device, and electronic device may be implemented in other manners.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A high electron mobility transistor HEMT device, comprising a substrate, a nitride epitaxial layer, a gate semiconductor structure, a gate metal, a source structure, and a drain structure; wherein
the nitride epitaxial layer is disposed on the substrate, the gate semiconductor structure is disposed on a first surface of the nitride epitaxial layer, and the first surface is a surface that is of the nitride epitaxial layer and that is away from the substrate;
the source structure and the drain structure are disposed on the first surface and distributed on two sides of the gate semiconductor structure;
the gate semiconductor structure comprises a first semiconductor layer, the first semiconductor layer is made of a p-type nitride, and the first semiconductor layer is located on the first surface; and
the gate semiconductor structure further comprises a plurality of n-type semiconductors, the plurality of n-type semiconductors are located between the first semiconductor layer and the gate metal, the plurality of n-type semiconductors are arranged at spacings in a same direction, and the arrangement direction of the plurality of n-type semiconductors is parallel to a gate width direction of the gate semiconductor structure.

2. The HEMT device according to claim 1, wherein the first semiconductor layer comprises a plurality of first protrusion portions, the plurality of n-type semiconductors are disposed in the first semiconductor layer, and every two of the n-type semiconductors are separated by the first protrusion portion.

3. The HEMT device according to claim 2, wherein a surface that is of at least one of the n-type semiconductors and that is close to the gate metal is coplanar with a surface that is of at least one of the first protrusion portions and that is close to the gate metal.

4. The HEMT device according to any one of claims 1 to 3, wherein the gate semiconductor structure further comprises a second semiconductor layer, and the second semiconductor layer is made of a p-type nitride; and
the second semiconductor layer is located on a surface that is of the gate metal and that is close to the first semiconductor layer.

5. The HEMT device according to claim 1, wherein the gate metal comprises a plurality of second protrusion portions, the plurality of n-type semiconductors are disposed in the gate metal, and every two of the n-type semiconductors are separated by the second protrusion portion.

6. The HEMT device according to claim 1, wherein space between the plurality of n-type semiconductors is filled with an insulation dielectric.

7. The HEMT device according to any one of claims 1 to 6, wherein the plurality of n-type semiconductors are arranged at equal spacings.

8. The HEMT device according to any one of claims 1 to 7, wherein the substrate is a heterogeneous epitaxial substrate or a homogeneous epitaxial substrate, the heterogeneous epitaxial substrate is made of silicon, sapphire, or silicon carbide, and the homogeneous epitaxial substrate is made of gallium nitride.

9. The HEMT device according to any one of claims 1 to 8, wherein the nitride epitaxial layer comprises a nucleation layer disposed on the substrate, a buffer layer disposed on the nucleation layer, a channel layer disposed on the buffer layer, and a barrier layer disposed on the channel layer; and
the nucleation layer is made of aluminum nitride, the buffer layer is made of aluminum gallium nitride or gallium nitride, the channel layer is made of undoped gallium nitride, and the barrier layer is made of aluminum gallium nitride, indium aluminum nitride, or indium aluminum gallium nitride.

10. The HEMT device according to any one of claims 1 to 9, wherein the source structure and the drain structure are symmetrically distributed on the two sides of the gate semiconductor structure.

11. The HEMT device according to any one of claims 1 to 10, wherein the first semiconductor layer or the second semiconductor layer is made of gallium nitride, aluminum gallium nitride, indium gallium nitride, indium aluminum nitride, or indium aluminum gallium nitride.

12. A HEMT device, comprising a substrate, a nitride epitaxial layer, a gate semiconductor structure, a gate metal, a source structure, and a drain structure; wherein
the nitride epitaxial layer is disposed on the substrate, the gate semiconductor structure is disposed on a first surface of the nitride epitaxial layer, and the first surface is a surface that is of the nitride epitaxial layer and that is away from the substrate;
the source structure and the drain structure are disposed on the first surface and distributed on two sides of the gate semiconductor structure;
the gate semiconductor structure comprises a first semiconductor layer, the first semiconductor layer is made of a p-type nitride, and the first semiconductor layer is located on the first surface;
the gate semiconductor structure further comprises a second semiconductor layer, the second semiconductor layer is a p-type semiconductor layer, an n-type semiconductor layer, or an unintentionally doped semiconductor layer, and the second semiconductor layer is located on a surface that is of the gate metal and that is close to the first semiconductor layer; and
a band gap width of the second semiconductor layer is greater than a band gap width of the first semiconductor layer, or a total polarization intensity of the second semiconductor layer is greater than a total polarization intensity of the first semiconductor layer.

13. The HEMT device according to claim 12, wherein the second semiconductor layer is made of a nitride comprising an aluminum component.

14. The HEMT device according to claim 13, wherein the first semiconductor layer is made of a nitride comprising an aluminum component; and
a percentage of the aluminum component at the first semiconductor layer is lower than a percentage of the aluminum component at the second semiconductor layer.

15. The HEMT device according to claim 13 or 14, wherein the percentage of the aluminum component at the second semiconductor layer is kept uniform;
the percentage of the aluminum component at the second semiconductor layer gradually decreases in a direction from the gate metal to the first semiconductor layer; or
the percentage of the aluminum component at the second semiconductor layer gradiently decreases in a direction from the gate metal to the first semiconductor layer.

16. The HEMT device according to any one of claims 12 to 15, wherein a doping density of the second semiconductor layer is kept uniform;
a doping density of the second semiconductor layer gradually increases in the direction from the gate metal to the first semiconductor layer; or
a doping density of the second semiconductor layer gradiently increases in the direction from the gate metal to the first semiconductor layer.

17. The HEMT device according to any one of claims 12 to 16, wherein the substrate is a heterogeneous epitaxial substrate or a homogeneous epitaxial substrate, the heterogeneous epitaxial substrate is made of silicon, sapphire, or silicon carbide, and the homogeneous epitaxial substrate is made of gallium nitride.

18. The HEMT device according to any one of claims 12 to 17, wherein the nitride epitaxial layer comprises a nucleation layer disposed on the substrate, a buffer layer disposed on the nucleation layer, a channel layer disposed on the buffer layer, and a barrier layer disposed on the channel layer; and
the nucleation layer is made of aluminum nitride, the buffer layer is made of aluminum gallium nitride or gallium nitride, the channel layer is made of undoped gallium nitride, and the barrier layer is made of aluminum gallium nitride, indium aluminum nitride, or indium aluminum gallium nitride.

19. The HEMT device according to any one of claims 12 to 18, wherein the source and the drain are symmetrically distributed on the two sides of the gate semiconductor structure.

20. The HEMT device according to any one of claims 12 to 19, wherein the first semiconductor layer or the second semiconductor layer is made of gallium nitride, aluminum gallium nitride, indium gallium nitride, indium aluminum nitride, or indium aluminum gallium nitride.

21. A wafer, wherein the wafer comprises the HEMT device according to any one of claims 1 to 20.

22. A packaged device, wherein the packaged device comprises the HEMT device according to any one of claims 1 to 20.

23. An electronic device, wherein the electronic device comprises the HEMT device according to any one of claims 1 to 20.

24. An electronic device, wherein the electronic device comprises a charging integrated circuit, a wired charging interface, and at least one HEMT device according to any one of claims 1 to 20, and the at least one HEMT device comprises a first HEMT device;
a gate structure of the first HEMT device is connected to a first control terminal of the charging integrated circuit, a drain structure of the first switching device is connected to the wired charging interface, and a source structure of the first switching device is connected to an input terminal of the charging integrated circuit; and
an output terminal of the charging integrated circuit is connected to a battery.

25. The electronic device according to claim 24, wherein the electronic device further comprises a wireless receiver integrated circuit and a wireless charging coil, and the at least one HEMT device further comprises a second HEMT device; and
a gate structure of the second HEMT device is connected to a second control terminal of the charging integrated circuit, a drain structure of the second HEMT device is connected to the wireless charging coil by using the wireless receiver integrated circuit, and a source structure of the second HEMT device is connected to the input terminal of the charging integrated circuit.
